# EUROPEAN PATENT APPLICATION

(11) **EP 4 756 804 A2**
(43) Date of publication of application: **10.06.2026**
(21) Application number: 25219937.7
(22) Date of filing: 02.12.2025
(51) Int. Cl.: G11C 5/02, G11C 7/10, G11C 16/26

(54) **MEMORY SYSTEM AND SEMICONDUCTOR MEMORY DEVICE**

(30) Priority: 05.12.2024 JP 2024212029
(71) Applicant: Kioxia Corporation, Tokyo (JP)
(72) Inventor: Sugahara, Akio, Tokyo (JP)
(74) Representative: Hoffmann Eitle

(57) **Abstract**

A memory system includes a plurality of semiconductor memory devices and a control device. Each of the plurality of semiconductor memory devices includes a first memory cell array, a second memory cell array, a first data signal input/output terminal usable for an output of data read from the first memory cell array, a second data signal input/output terminal usable for an output of data read from the second memory cell array, and a first control terminal configured to accept a toggle signal from the control device at a time of outputting data read from the first memory cell array or the second memory cell array. The control device toggles a signal of the first control terminal at an approximately constant frequency regardless of whether or not an input/output of data via the first data signal input/output terminal or the second data signal input/output terminal is being executed.

## Description

### BACKGROUND

### Field

Embodiments described herein relate generally to a memory system and a semiconductor memory device.

### Description of the Related Art

There has been known a memory system including a plurality of semiconductor memory devices and a control device. The semiconductor memory device includes a memory cell array including a plurality of first memory cell transistors connected in series.

### BRIEF DESCRIPTION OF THE DRAWINGS

FIG. 1 is a schematic block diagram illustrating a configuration of a memory system 10;
FIG. 2 is a schematic side view illustrating an exemplary configuration of a package PKG included in the memory system 10;
FIG. 3 is a schematic plan view illustrating an exemplary configuration of the package PKG included in the memory system 10;
FIG. 4 is a schematic exploded perspective view illustrating an exemplary configuration of a memory die MD;
FIG. 5 is a schematic bottom view illustrating an exemplary configuration of a chip C_{M};
FIG. 6 is a schematic plan view illustrating an exemplary configuration of a chip C_{P};
FIG. 7 is a schematic circuit diagram illustrating a configuration of a part of a memory cell array MCA;
FIG. 8 is a schematic circuit diagram illustrating a configuration of a part of a memory block BLK;
FIG. 9 is a schematic block diagram illustrating a configuration of a peripheral circuit PC;
FIG. 10 is a schematic circuit diagram illustrating a configuration of a part of the peripheral circuit PC;
FIG. 11 is a schematic block diagram for describing signal paths for user data Dat of the memory die MD according to the first embodiment;
FIG. 12 is a schematic block diagram for describing a signal path for user data Dat of a memory die MD' according to a comparative example;
FIG. 13 is a schematic diagram for describing roles of signal input/output terminals and control terminals in the memory die MD;
FIG. 14 is a schematic waveform diagram for describing an operation of the memory die MD;
FIG. 15 is a schematic table for describing the operation of the memory die MD;
FIG. 16 is a schematic waveform diagram illustrating input/output signals between a controller die CD and the memory die MD;
FIG. 17 is a schematic waveform diagram illustrating input/output signals between the controller die CD and the memory die MD;
FIG. 18 is a schematic waveform diagram illustrating input/output signals between the controller die CD and the memory die MD;
FIG. 19 is a schematic waveform diagram illustrating input/output signals between the controller die CD and the memory die MD;
FIG. 20 is a schematic waveform diagram illustrating input/output signals between the controller die CD and the memory die MD;
FIG. 21 is a schematic waveform diagram illustrating input/output signals between the controller die CD and the memory die MD;
FIG. 22 is a schematic waveform diagram illustrating input/output signals between the controller die CD and the memory die MD;
FIG. 23 is a schematic waveform diagram illustrating input/output signals between the controller die CD and the memory die MD;
FIG. 24 is a schematic waveform diagram illustrating input/output signals between the controller die CD and the memory die MD;
FIG. 25 is a schematic waveform diagram illustrating input/output signals between the controller die CD and the memory die MD;
FIG. 26 is a schematic waveform diagram illustrating input/output signals between the controller die CD and the memory die MD;
FIG. 27 is a schematic waveform diagram illustrating input/output signals between the controller die CD and the memory die MD;
FIG. 28 is a schematic waveform diagram illustrating input/output signals between the controller die CD and the memory die MD;
FIG. 29 is a schematic waveform diagram illustrating input/output signals between the controller die CD and the memory die MD; and
FIG. 30 is a schematic waveform diagram illustrating input/output signals between the controller die CD and the memory die MD.

### DETAILED DESCRIPTION

A memory system according to one embodiment comprises a plurality of semiconductor memory devices and a control device. Each of the plurality of semiconductor memory devices includes: a first memory cell array including a plurality of first memory cell transistors connected in series; a second memory cell array including a plurality of second memory cell transistors connected in series; a first data signal input/output terminal usable for an output of data read from the first memory cell array and an input of data to be written to the first memory cell array; a second data signal input/output terminal usable for an output of data read from the second memory cell array and an input of data to be written to the second memory cell array; and a first control terminal configured to accept a toggle signal from the control device at a time of outputting data read from at least one of the first memory cell array and the second memory cell array. The control device toggles a signal of the first control terminal at an approximately constant frequency regardless of whether or not an input/output of data via the first data signal input/output terminal or the second data signal input/output terminal is being executed.

Next, the memory systems according to embodiments are described in detail with reference to the drawings. The following embodiments are only examples, and not described for the purpose of limiting the present invention. For convenience of description, a part of a configuration and the like is sometimes omitted. Parts common in a plurality of embodiments are attached by same reference numerals and their descriptions may be omitted.

In this specification, when referring to a "memory system", it may mean a system including a controller die, such as a memory card, and a Solid State Drive (SSD). Further, it may mean a configuration including a host computer, such as a smartphone, a tablet terminal, and a personal computer.

In this specification, when it is referred that a first configuration "is electrically connected" to a second configuration, the first configuration may be directly connected to the second configuration, and the first configuration may be connected to the second configuration via a wiring, a semiconductor member, a transistor, or the like. For example, when three transistors are connected in series, even when the second transistor is in an OFF state, the first transistor is "electrically connected" to the third transistor.

In this specification, when it is referred that the first configuration "is connected between" the second configuration and a third configuration, it may mean that the first configuration, the second configuration, and the third configuration are connected in series and the second configuration is connected to the third configuration via the first configuration.

In this specification, a direction parallel to an upper surface of the substrate is referred to as an X-direction, a direction parallel to the upper surface of the substrate and perpendicular to the X-direction is referred to as a Y-direction, and a direction perpendicular to the upper surface of the substrate is referred to as a Z-direction.

### [Embodiments]

### [Memory System 10]

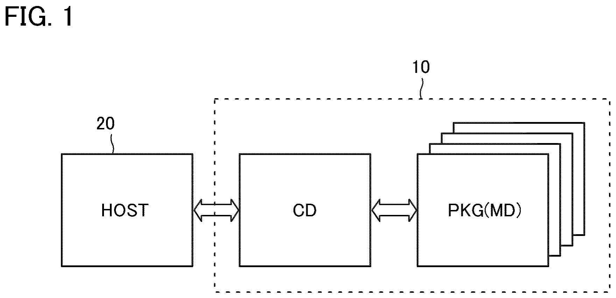

FIG. 1 is a schematic block diagram illustrating a configuration of a memory system 10 according to an embodiment.

The memory system 10, for example, reads, writes, and erases user data according to a signal transmitted from a host computer 20. The memory system 10 is, for example, any system that can store user data including a memory card and an SSD. The memory system 10 includes a plurality of packages PKG and a controller die CD connected to these plurality of packages PKG and the host computer 20. Each package PKG includes a plurality of memory dies MD. Each memory die MD can store user data. The controller die CD includes, for example, a processor, a RAM, and the like, and performs conversion between a logical address and a physical address, bit error detection/correction, a garbage collection (compaction), a wear leveling, and the like.

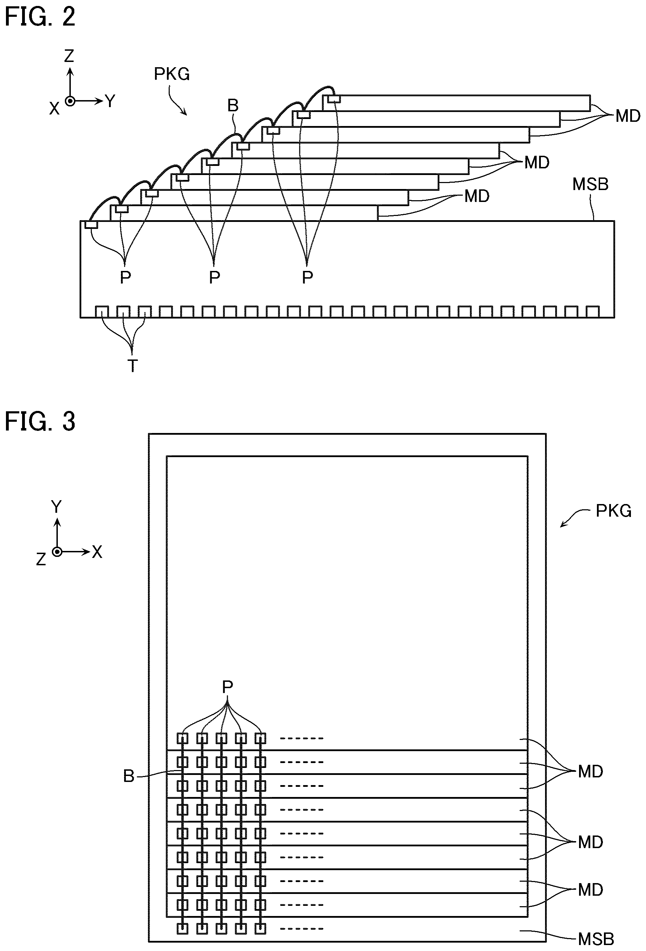

FIG. 2 is a schematic side view illustrating an exemplary configuration of the package PKG included in the memory system 10 according to the embodiment. FIG. 3 is a schematic plan view illustrating an exemplary configuration of the package PKG included in the memory system 10 according to the embodiment. For convenience of explanation, a part of the configuration is omitted in FIG. 2 and FIG. 3.

As illustrated in FIG. 2, the package PKG according to the embodiment includes a memory die mounting substrate MSB and a plurality of memory dies MD stacked on the memory die mounting substrate MSB. On an upper surface of the memory die mounting substrate MSB, pad electrodes P are disposed in a region at an end portion in a Y-direction, and a part of another region is bonded to a lower surface of a memory die MD via an adhesive and the like. On an upper surface of the memory die MD, pad electrodes P are disposed in a region at an end portion in the Y-direction, and another region is bonded to a lower surface of another memory die MD via the adhesive and the like. The pad electrodes P corresponding between the plurality of memory dies MD are connected in common via bonding wires B. Electrode terminals T are disposed on a lower surface of the memory die mounting substrate MSB. The pad electrodes P on the upper surface of the memory die mounting substrate MSB are connected to the respective electrode terminals T on the lower surface. The memory die mounting substrate MSB may be, for example, a grid array substrate. On the upper surface of the memory die mounting substrate MSB, the plurality of memory dies MD and the bonding wires B are covered with, for example, sealing resin (not illustrated).

In addition, as illustrated in FIG. 3, the memory die mounting substrate MSB and the plurality of memory dies MD each include a plurality of the pad electrodes P arranged in the X-direction. The respective plurality of pad electrodes P of each of the memory dies MD correspond to control terminals /CE, CA1 (CLE), CA0 (ALE), CA_clk (/WE), /RE, RE, /WP, data signal input/output terminals DQ0 to DQ7, data strobe signal input/output terminals DQS, /DQS, and a terminal RY//BY described later.

The respective plurality of pad electrodes P disposed on the memory die mounting substrate MSB and the plurality of memory dies MD are connected to one another via the bonding wires B. For example, the pad electrodes P corresponding to the control terminals CA1 (CLE) in the plurality of memory dies MD are connected to one another, and the pad electrodes P corresponding to the control terminals CA0 (ALE) are connected to one another. The same applies to other terminals. In addition, the pad electrodes P of each memory die MD inside the package PKG are connected to an outside of the package PKG via the electrode terminals T on the lower surface of the memory die mounting substrate MSB.

Note that the configurations illustrated in FIG. 2 and FIG. 3 are merely examples, and specific configurations are appropriately adjustable. For example, in the example illustrated in FIG. 2, a plurality of memory dies MD are stacked, and these configurations are connected with the bonding wires B. However, the plurality of memory dies MD may be connected to one another via through electrodes or the like, not the bonding wires B.

### [Memory Die MD]

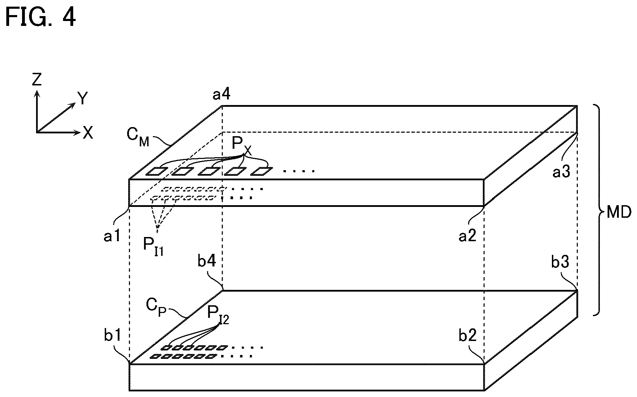

FIG. 4 is a schematic exploded perspective view illustrating an exemplary configuration of the memory die MD according to the embodiment. As illustrated in FIG. 4, the memory die MD includes a chip C_{M} at a memory cell array side and a chip C_{P} at a peripheral circuit side.

A plurality of external pad electrodes P_{X} connectable to bonding wires (not illustrated in FIG. 4) are disposed on an upper surface of the chip C_{M}. Additionally, a plurality of bonding electrodes P_{I1} are disposed on a lower surface of the chip C_{M}. A plurality of bonding electrodes P_{I2} are disposed on an upper surface of the chip C_{P}. Hereinafter, regarding the chip C_{M}, a surface on which the plurality of bonding electrodes P_{I1} are disposed is referred to as a front surface, and a surface on which the plurality of external pad electrodes P_{X} are disposed is referred to as a back surface. In addition, regarding the chip C_{P}, a surface on which the plurality of bonding electrodes P_{I2} are disposed is referred to as a front surface, and a surface on a side opposite to the front surface is referred to as a back surface. In the illustrated example, the front surface of the chip C_{P} is disposed above the back surface of the chip C_{P}, and the back surface of the chip C_{M} is disposed above the front surface of the chip C_{M}.

The chip C_{M} and the chip C_{P} are placed such that the front surface of the chip C_{M} faces the front surface of the chip C_{P}. The plurality of bonding electrodes P_{I1} are disposed corresponding to the respective plurality of bonding electrodes P_{I2} and are placed at positions where the plurality of bonding electrodes P_{I1} can be bonded to the plurality of bonding electrodes P_{I2}. The bonding electrodes P_{I1} and the bonding electrodes P_{I2} function as bonding electrodes for bonding the chip C_{M} and the chip C_{P} and electrically conducting them.

Note that in the example of FIG. 4, corner portions a1, a2, a3, a4 of the chip C_{M} correspond to corner portions b1, b2, b3, b4 of the chip C_{P}, respectively.

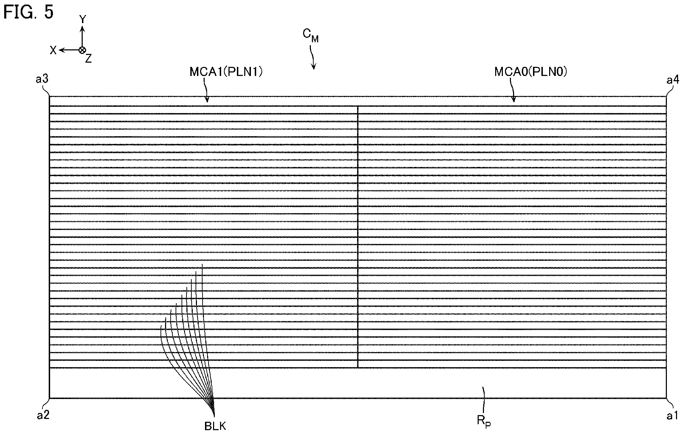

FIG. 5 is a schematic bottom view illustrating an exemplary configuration of the chip C_{M}. For example, as illustrated in FIG. 5, the chip C_{M} includes two memory cell arrays MCAO, MCA1 arranged in the X-direction. The memory cell arrays MCAO, MCA1 include a plurality of memory blocks BLK arranged in the Y-direction. Additionally, the chip C_{M} includes a peripheral region R_{P} disposed on one end side in the Y-direction with respect to the two memory cell arrays MCAO, MCA1. In the following description, the memory cell arrays MCAO, MCA1 are referred to as a memory cell array MCA in some cases. The memory cell arrays MCAO, MCA1 are referred to as planes PLNO, PLN1 in some cases.

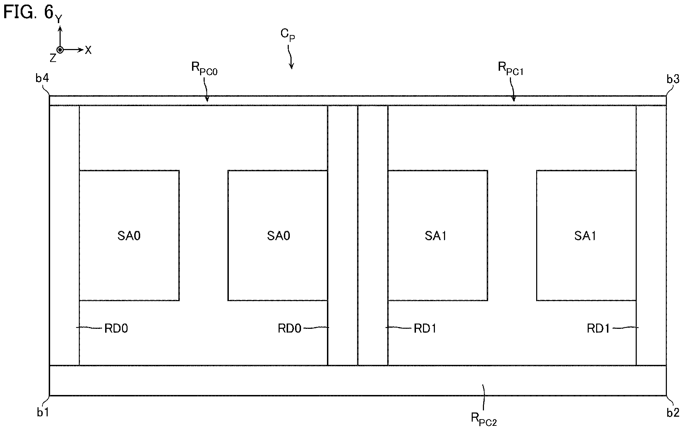

FIG. 6 is a schematic plan view illustrating an exemplary configuration of the chip C_{P}. For example, as illustrated in FIG. 6, the chip C_{P} includes two circuit regions R_{PC0}, R_{PC1} disposed at positions facing the two memory cell arrays MCAO, MCA1. The circuit regions R_{PC0}, R_{PC1} include sense amplifiers SA0, SA1 and row decoders RD0, RD1 described later, respectively. Additionally, the chip C_{P} includes a circuit region R_{PC2} disposed on one end side in the Y-direction with respect to the two circuit regions R_{PC0}, R_{PC1}. A peripheral circuit is disposed in the circuit regions R_{PC0}, R_{PC1}, R_{PC2}.

### [Configuration of Memory Cell Array MCA]

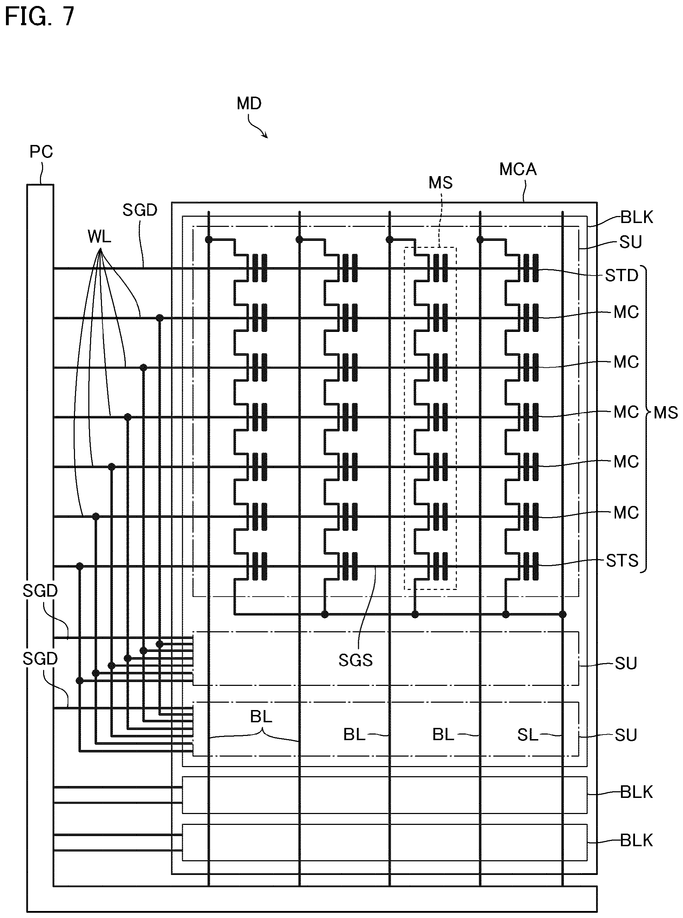

FIG. 7 is a schematic circuit diagram illustrating a configuration of a part of the memory cell array MCA. As described above, the memory cell array MCA includes a plurality of memory blocks BLK. Each of these plurality of memory blocks BLK includes a plurality of string units SU. Each of these plurality of string units SU includes a plurality of memory strings MS. Each of these plurality of memory strings MS has one end connected to a peripheral circuit PC via a bit line BL. In addition, each of these plurality of memory strings MS has the other end connected to the peripheral circuit PC via a common source line SL.

The memory string MS includes a drain-side select transistor STD, a plurality of memory cells MC (memory cell transistors), and a source-side select transistor STS, which are connected in series between the bit line BL and the source line SL. Hereinafter, the drain-side select transistor STD and the source-side select transistor STS may be simply referred to as select transistors STD, STS.

The memory cell MC is a field-effect type transistor including a semiconductor layer, a gate insulating film, and a gate electrode. The semiconductor layer functions as a channel region. The gate insulating film includes an electric charge accumulating film. The memory cell MC has a threshold voltage that changes according to an electric charge amount in the electric charge accumulating film. The memory cell MC stores one bit or a plurality of bits of user data. Respective word lines WL are connected to the gate electrodes of the plurality of memory cells MC corresponding to one memory string MS. Each of these word lines WL is connected in common to all the memory strings MS in one memory block BLK.

The select transistors STD, STS are field-effect type transistors that include semiconductor layers, gate insulating films, and gate electrodes. The semiconductor layer functions as a channel region. Select gate lines SGD, SGS are connected to the gate electrodes of the select transistors STD, STS, respectively. The drain-side select gate line SGD is disposed corresponding to the string unit SU and connected in common to all the memory strings MS in one string unit SU. The source-side select gate line SGS is connected in common to all the memory strings MS in the memory block BLK.

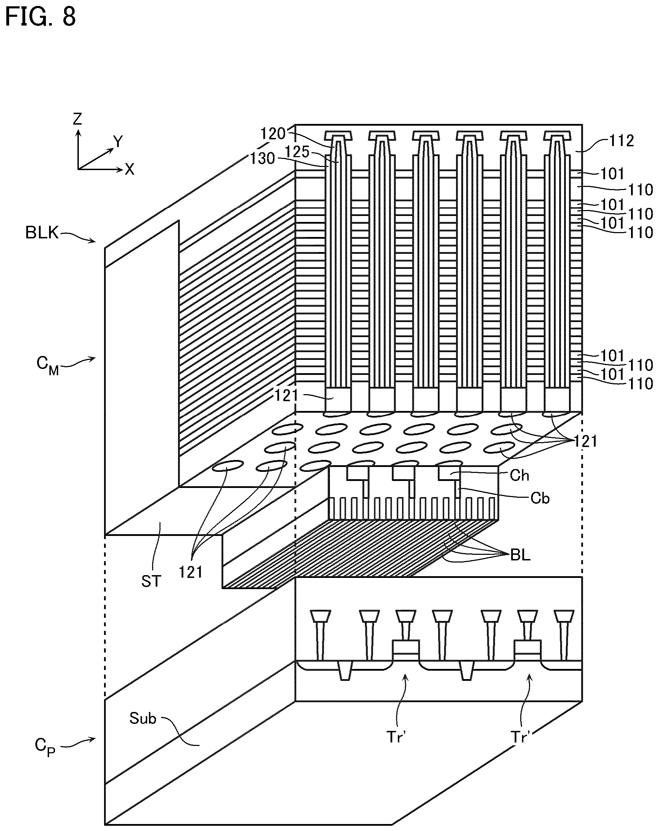

FIG. 8 is a schematic circuit diagram illustrating a configuration of a part of the memory block BLK. For example, as illustrated in FIG. 8, the memory block BLK is disposed above a semiconductor substrate Sub in the chip C_{P}. A plurality of transistors Tr constituting the peripheral circuit PC are disposed on a main surface of the semiconductor substrate Sub.

The memory block BLK includes a plurality of conductive layers 110 arranged in the Z-direction, a plurality of semiconductor columns 120 extending in the Z-direction, and a respective plurality of gate insulating films 130 disposed between the plurality of conductive layers 110 and the plurality of semiconductor columns 120.

The conductive layer 110 is an approximately plate-shaped conductive layer extending in the X-direction. The conductive layers 110 may include, for example, a stacked film of a barrier conductive film of titanium nitride (TiN) or the like and a metal film of tungsten (W) or the like. Further, the conductive layers 110 may include, for example, polycrystalline silicon containing impurities, such as phosphorus (P) or boron (B). Between the respective adjacent plurality of conductive layers 110 arranged in the Z-direction, insulating layers 101 of silicon oxide (SiO₂) or the like are disposed.

Among the plurality of conductive layers 110, one or a plurality of the conductive layers 110 positioned at the uppermost layer function as the source-side select gate line SGS (FIG. 7) and the gate electrodes of the plurality of source-side select transistors STS (FIG. 7) connected to the source-side select gate line SGS. These plurality of conductive layers 110 are electrically independent for each memory block BLK.

A plurality of the conductive layers 110 positioned below these conductive layers 110 function as the word lines WL (FIG. 7) and the gate electrodes of a plurality of the memory cells MC (FIG. 7) connected to the word lines WL. These plurality of conductive layers 110 are each electrically independent for each memory block BLK.

One or a plurality of the conductive layers 110 positioned below these conductive layers 110 function as the drain-side select gate line SGD and the gate electrodes of a plurality of the drain-side select transistors STD (FIG. 7) connected to the drain-side select gate line SGD. These plurality of conductive layers 110 have widths in the Y-direction smaller than those of the other conductive layers 110.

A semiconductor layer 112 is disposed above the conductive layers 110. The semiconductor layer 112 may include, for example, polycrystalline silicon containing impurities, such as phosphorus (P) or boron (B). The insulating layer 101 of silicon oxide (SiO₂) or the like is disposed between the semiconductor layer 112 and the conductive layers 110.

The semiconductor layer 112 functions as the source line SL (FIG. 7). The source line SL is disposed, for example, in common to all the memory blocks BLK included in the memory cell array MCA.

The semiconductor columns 120 are arranged in a predetermined pattern in the X-direction and the Y-direction. The semiconductor columns 120 function as the channel regions of the plurality of memory cells MC and the select transistors STD, STS included in one memory string MS (FIG. 7). The semiconductor column 120 is, for example, a semiconductor layer of polycrystalline silicon (Si) or the like. The semiconductor column 120 has an approximately closed-bottomed cylindrical shape and includes an insulating layer 125 of silicon oxide or the like in a center portion. An outer peripheral surface of each semiconductor column 120 is surrounded by the conductive layers 110 and faces the conductive layers 110.

An impurity region 121 containing N-type impurities, such as phosphorus (P), is disposed on a lower end portion of the semiconductor column 120. The impurity region 121 is connected to the bit line BL via a contact Ch and a contact Cb.

The gate insulating film 130 has an approximately cylindrical shape that covers the outer peripheral surface of the semiconductor column 120. The gate insulating film 130 includes, for example, a tunnel insulating film, an electric charge accumulating film, and a block insulating film, which are stacked between the semiconductor column 120 and the conductive layers 110. The tunnel insulating film and the block insulating film are, for example, insulating films of silicon oxide (SiO₂) or the like. The electric charge accumulating film is, for example, a film of silicon nitride (Si₃N₄) or the like that can accumulate electric charges. The tunnel insulating film, the electric charge accumulating film, and the block insulating film have approximately cylindrical shapes and extend in the Z-direction along the outer peripheral surface of the semiconductor column 120 excluding a contact portion between the semiconductor column 120 and the semiconductor layer 112.

The gate insulating film 130 may include, for example, a floating gate of polycrystalline silicon or the like containing N-type or P-type impurities.

### [Configuration of Peripheral Circuit PC]

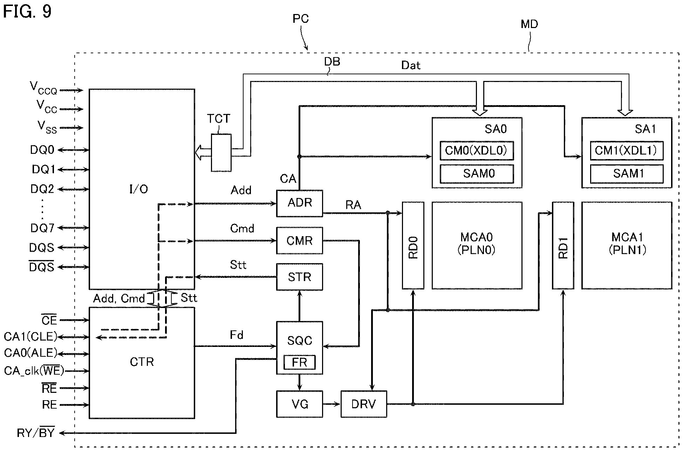

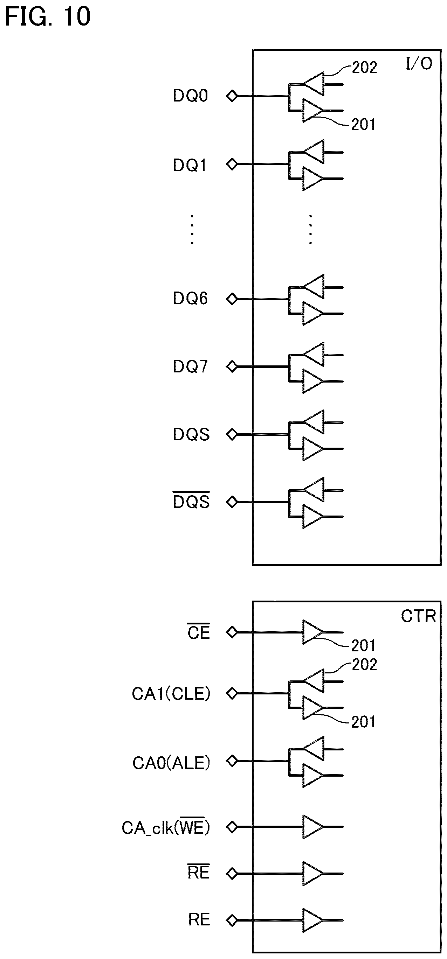

FIG. 9 is a schematic block diagram illustrating a configuration of the peripheral circuit PC. FIG. 10 is a schematic circuit diagram illustrating a configuration of a part of the peripheral circuit PC. For convenience of explanation, a part of the configuration is omitted in FIG. 9 and FIG. 10.

FIG. 9 and the like illustrate a plurality of control terminals and the like. These plurality of control terminals are represented as control terminals corresponding to a high active signal (positive logic signal) in some cases, represented as control terminals corresponding to a low active signal (negative logic signal) in some cases, and represented as control terminals corresponding to both the high active signal and the low active signal in some cases. In FIG. 9, a reference sign of the control terminal corresponding to the low active signal includes an overline (overbar). In this specification, a reference sign of the control terminal corresponding to the low active signal includes a slash ("/"). The description of FIG. 9 is an example, and specific aspects are appropriately adjustable. For example, a part of or all of the high active signals can be changed to the low active signals, or a part of or all of the low active signals can be changed to the high active signals.

Next to the plurality of control terminals illustrated in FIG. 9, an arrow indicating an input/output direction is illustrated. In FIG. 9, the control terminals provided with an arrow pointing from left to right are usable for an input of data or other signals from the controller die CD to the memory die MD. In FIG. 9, the control terminals provided with an arrow pointing from right to left are usable for an output of data or other signals from the memory die MD to the controller die CD. In FIG. 9, the control terminals provided with an arrow pointing to both left and right directions are usable in both directions for an input of data or other signals from the controller die CD to the memory die MD and for an output of data or other signals from the memory die MD to the controller die CD.

For example, as illustrated in FIG. 9, the peripheral circuit PC includes the row decoders RD0, RD1, which are connected to the memory cell arrays MCAO, MCA1, respectively, and the sense amplifiers SA0, SA1. The peripheral circuit PC further includes a driver circuit DRV, a voltage generation circuit VG, and a sequencer SQC. In addition, the peripheral circuit PC includes an input/output control circuit I/O, a logic circuit CTR, an address register ADR, a command register CMR, a status register STR, and a data output timing adjustment unit TCT. In the following description, the row decoders RD0, RD1 are referred to as a row decoder RD, and the sense amplifiers SA0, SA1 are referred to as a sense amplifier SA in some cases.

The row decoder RD decodes a row address RA in an address data Add and electrically conducts all the word lines WL (FIG. 7) included in one of the plurality of memory blocks BLK with the driver circuit DRV.

The sense amplifiers SA0, SA1 include sense amplifier modules SAMO, SAM1 and cache memories CM0, CM1, respectively. The cache memories CM0, CM1 include latch circuits XDL0, XDL1, respectively.

In the following description, the sense amplifier modules SAMO, SAM1 are referred to as a sense amplifier module SAM, the cache memories CM0, CM1 are referred to as a cache memory CM, and the latch circuits XDLO, XDL1 are referred to as a latch circuit XDL, in some cases.

For example, the sense amplifier module SAM includes sense circuits electrically connected to the respective plurality of bit line BL (FIG. 7), a plurality of latch circuits connected to the sense circuits, and the like.

The cache memory CM includes a plurality of the latch circuits XDL. The plurality of latch circuits XDL are electrically connected to the respective latch circuits in the sense amplifier module SAM. In the latch circuit XDL, for example, user data Dat to be written to the memory cell MC or user data Dat read from the memory cell MC is stored.

The voltage generation circuit VG includes, for example, a step-down circuit, such as a regulator, and a step-up circuit, such as a charge pump circuit. These step-down circuit and step-up circuit are each connected to a voltage supply line to which a power supply voltage V_{CC} is applied and a voltage supply line to which a ground voltage V_{SS} is applied. These voltage supply lines are connected to, for example, the pad electrodes P described with reference to FIG. 2 and FIG. 3. For example, the voltage generation circuit VG generates and outputs a plurality of operating voltages applied to the bit lines BL, the source line SL, the word lines WL, and the select gate lines SGD, SGS in a read operation, a write operation, and an erase operation on the memory cell array MCA according to the control signal from the sequencer SQC. These plurality of operating voltages are appropriately adjusted according to the control signal from the sequencer SQC.

The driver circuit DRV decodes the row address RA in the address data Add, electrically conducts one of the plurality of word lines WL with a voltage supply line corresponding to a selected word line, and electrically conducts the other word lines WL with voltage supply lines corresponding to unselected word lines. One of the plurality of drain-side select gate lines SGD is electrically conducted with a predetermined voltage supply line, and the other drain-side select gate lines SGD are electrically conducted with the other voltage supply lines.

In addition, the driver circuit DRV electrically conducts the voltage supply line corresponding to the above-described selected word line, the voltage supply lines corresponding to the unselected word lines, the predetermined voltage supply line, and the other voltage supply lines with the step-down circuit, the step-up circuit, the voltage supply line to which the power supply voltage V_{CC} is applied, or the voltage supply line to which the ground voltage V_{SS} is applied as appropriate according to the control signal from the sequencer SQC.

The sequencer SQC (FIG. 9) outputs an internal control signal to the row decoders RD0, RD1, the sense amplifier modules SAMO, SAM1, the driver circuit DRV, and the voltage generation circuit VG according to command data Cmd stored in the command register CMR. Further, the sequencer SQC appropriately outputs status data Stt indicating a state of the memory die MD to the status register STR. The state of the memory die MD includes ready/busy states of the memory die MD. Hereinafter, the ready/busy states are simply referred to as a "ready-busy state" in some cases.

The sequencer SQC generates a ready/busy signal and outputs it to a terminal RY//BY. For example, the terminal RY//BY enters an "L" state during operations where a voltage is applied to the memory cell array MCA, such as the read operation, write operation, and erase operation, and during executions of get feature, set feature, and the like described later, and enters an "H" state in the other cases. Even when operations where a voltage is not applied to the memory cell array MCA, such as a data-out operation and a status read, are executed, the terminal RY//BY does not enter the "L" state. In a period where the terminal RY//BY is in the "L" state (busy period), an access to the memory die MD is basically inhibited. In a period where the terminal RY//BY is in the "H" state (ready period), the access to the memory die MD is permitted. The terminal RY//BY is achieved by, for example, the pad electrode P described with reference to FIG. 2 and FIG. 3.

The sequencer SQC includes a feature register FR. The feature register FR is a register that latches feature data Fd. The feature data Fd includes, for example, control parameters and the like of the memory die MD.

The address register ADR is connected to the input/output control circuit I/O and stores the address data Add input from the input/output control circuit I/O. For example, the address register ADR includes a plurality of 8-bit register strings. For example, when an internal operation, such as a read operation, write operation, or erase operation, is executed, the register string latches the address data Add corresponding to the internal operation in execution.

The address data Add includes, for example, a column address CA (FIG. 9) and the row address RA (FIG. 9). For example, the row address RA includes a block address to identify the memory block BLK (FIG. 7), a page address to identify the string unit SU and the word line WL, a plane address to identify the memory cell array MCA (plane), and a chip address to identify the memory die MD.

The command register CMR is connected to the input/output control circuit I/O and stores the command data Cmd input from the input/output control circuit I/O. For example, the command register CMR includes at least one set of an 8-bit register string. When the command data Cmd is stored in the command register CMR, the control signal is transmitted to the sequencer SQC.

The status register STR is connected to the input/output control circuit I/O and stores the status data Stt output to the input/output control circuit I/O. For example, the status register STR includes a plurality of 8-bit register strings. For example, when an internal operation, such as a read operation, write operation, or erase operation, is executed, the register string latches the status data Stt regarding the internal operation in execution. In addition, the register string, for example, latches ready/busy information indicating the ready-busy state of the memory cell arrays MCAO, MCA1.

The data output timing adjustment unit TCT is connected to a bus wiring DB between the cache memories CM0, CM1 and the input/output control circuit I/O. For example, when a data-out operation is consecutively executed for the cache memories CM0, CM1, the data output timing adjustment unit TCT, for example, adjusts a start timing of the data-out operation for the cache memory CM1 to start the data-out operation for the cache memory CM1 without any interval after the data-out operation for the cache memory CM0 is completed.

The input/output control circuit I/O includes data signal input/output terminals DQ0 to DQ7, data strobe signal input/output terminals DQS, /DQS, a shift register, a buffer circuit, and a connection change circuit SW.

The data signal input/output terminals DQ0 to DQ7 and the data strobe signal input/output terminals DQS, /DQS are achieved by, for example, the pad electrodes P described with reference to FIG. 2 and FIG. 3. The user data Dat input via the data signal input/output terminals DQ0 to DQ7 is input to the cache memory CM from the buffer circuit according to the internal control signal from the logic circuit CTR. In addition, the user data Dat to be output via the data signal input/output terminals DQ0 to DQ7 is input to the buffer circuit from the cache memory CM or the status register STR according to the internal control signal from the logic circuit CTR.

Signals input via the data strobe signal input/output terminals DQS, /DQS (for example, a data strobe signal and its complementary signal) are used, for example, at a time of inputting the user data Dat via the data signal input/output terminals DQ0 to DQ7. The user data Dat input via the data signal input/output terminals DQ0 to DQ7 are taken in the shift register in the input/output control circuit I/O at timings of a rising edge of a voltage at the data strobe signal input/output terminal DQS and a falling edge of a voltage at the data strobe signal input/output terminal /DQS and at timings of a falling edge of the voltage at the data strobe signal input/output terminal DQS and a rising edge of the voltage at the data strobe signal input/output terminal /DQS.

In addition, the data strobe signal input/output terminals DQS, /DQS are also used, for example, at a time of outputting the user data Dat via the data signal input/output terminals DQ0 to DQ7. The user data Dat to be output via the data signal input/output terminals DQ0 to DQ7 are switched at the timings of the rising edge of the voltage at the data strobe signal input/output terminal DQS and the falling edge of the voltage at the data strobe signal input/output terminal /DQS and at the timings of the falling edge of the voltage at the data strobe signal input/output terminal DQS and the rising edge of the voltage at the data strobe signal input/output terminal /DQS.

For example, as illustrated in FIG. 10, each of the data signal input/output terminals DQ0 to DQ7 and the data strobe signal input/output terminals DQS, /DQS is connected to an input circuit 201 and an output circuit 202. The input circuit 201 is, for example, a receiver, such as a comparator. The output circuit 202 is, for example, a driver of an Off Chip Driver (OCD) circuit or the like.

The logic circuit CTR includes a plurality of control terminals /CE, CA1 (CLE), CA0 (ALE), CA_clk (/WE), /RE, RE and a logic circuit connected to these plurality of control terminals /CE, CA1 (CLE), CA0 (ALE), CA_clk (/WE), /RE, RE. The logic circuit CTR receives an external control signal from the controller die CD via the control terminals /CE, CA1 (CLE), CA0 (ALE), CA_clk (/WE), /RE, RE and outputs an internal control signal to the input/output control circuit I/O according to this external control signal.

For example, as illustrated in FIG. 10, the control terminals /CE, CA1 (CLE), CA0 (ALE), CA_clk (/WE), /RE, RE are connected to input circuits 201. The control terminals CA1 (CLE), CA0 (ALE) are also connected to output circuits 202, in addition to the input circuits 201. The control terminals /CE, CA1 (CLE), CA0 (ALE), CA_clk (/WE), /RE, RE are achieved, for example, by the pad electrodes P described with reference to FIG. 2 and FIG. 3.

A signal input via the control terminal /CE (for example, a chip enable signal) is used at a time of selecting the memory die MD. The memory die MD where "L" is input to the control terminal /CE enters a state where an input/output of the user data Dat, the command data Cmd, the address data Add, and the status data Stt (hereinafter simply referred to as "data" in some cases) is possible. The memory die MD where "H" is input to the control terminal /CE enters a state where the input/output of data is not possible.

The functions of the control terminals CA1 (CLE), CA0 (ALE), CA_clk (/WE) is described later.

Signals input via the control terminals /RE, RE (for example, a read enable signal and its complementary signal) are used at a time of input/outputting data to and from the memory die MD. Here, as described later, the controller die CD inputs a plurality of command sets, commands, and the like to the memory die MD. In addition, the controller die CD acquires the user data Dat and the like from the memory die MD. During this time, the controller die CD continues to input a signal in the "L" state and a signal in the "H" state to the control terminals /RE, RE at an approximately constant pace regardless of whether or not the input/output of the user data Dat via the data signal input/output terminals DQ0 to DQ7 is being executed. That is, the controller die CD continues to toggle the input signals to the control terminals /RE, RE at an approximately constant frequency. The user data Dat to be output from the data signal input/output terminals DQ0 to DQ7 is switched at timings of a falling edge of a voltage at the control terminal /RE and a rising edge of a voltage at the control terminal RE and at timings of a rising edge of the voltage at the control terminal /RE and a falling edge of the voltage at the control terminal RE.

### [Signal Path for User Data Dat of Memory Die MD According to First Embodiment]

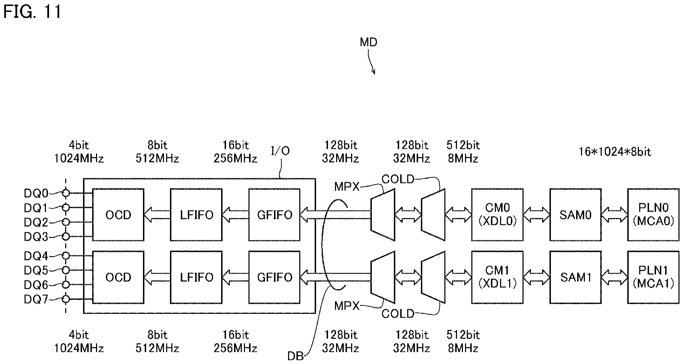

FIG. 11 is a schematic block diagram for describing signal paths for user data Dat of the memory die MD according to the first embodiment.

Each of the memory cell arrays MCAO, MCA1 includes, for example, 16×1024×8 (= 131,072) bit lines BL. Each of the sense amplifier modules SAMO, SAM1 includes 16×1024×8 latch circuits corresponding to these bit lines BL. Similarly, the cache memory CM0, CM1 include 16×1024×8 latch circuits XDLO, XDL1 corresponding to these latch circuits, respectively.

In the memory die MD according to the first embodiment, when the user data Dat is output, the user data Dat is transferred from the cache memories CM0, CM1 to the data signal input/output terminals DQ0 to DQ7 at an approximately constant speed (in the illustrated example, 4096 MHz).

For example, the cache memories CM0, CM1 are connected to respective column decoders COLD. The cache memories CM0, CM1 are connected to the column decoders COLD via, for example, respective 512-bit buses. The input/output of the user data Dat between the cache memories CM0, CM1 and the column decoders COLD is executed, for example, at 8 MHz.

The column decoders COLD are connected to respective multiplexers MPX. The column decoders COLD are connected to the multiplexers MPX via, for example, respective 128-bit buses. The input/output of the user data Dat between the column decoders COLD and the multiplexers MPX is executed, for example, at 32 MHz.

The input/output control circuit I/O includes buffer circuits GFIFO, LFIFO and a driver circuit OCD, which correspond to the memory cell array MCAO, and buffer circuits GFIFO, LFIFO and a driver circuit OCD, which correspond to the memory cell array MCA1.

The multiplexers MPX are connected to the respective buffer circuits GFIFO. The multiplexers MPX are connected to the buffer circuits GFIFO via, for example, respective 128-bit buses. The input/output of the user data Dat between the multiplexers MPX and the buffer circuits GFIFO is executed, for example, at 32 MHz.

The buffer circuits GFIFO are connected to the respective buffer circuits LFIFO. The buffer circuits GFIFO are connected to the buffer circuits LFIFO via, for example, respective 16-bit buses. The input/output of the user data Dat between the buffer circuits GFIFO and the buffer circuits LFIFO is executed, for example, at 256 MHz.

The driver circuit OCD corresponding to the memory cell array MCA0 includes four output circuits 202 (FIG. 10) corresponding to the data signal input/output terminals DQ0 to DQ3. That is, the user data Dat read from the memory cell array MCA0 is output via the data signal input/output terminals DQ0 to DQ3. The data signal input/output terminals DQ0 to DQ3 include a signal path for the user data Dat to and from the memory cell array MCAO, but do not include a signal path for the user data Dat to and from the memory cell array MCA1.

The driver circuit OCD corresponding to the memory cell array MCA1 includes four output circuits 202 (FIG. 10) corresponding to the data signal input/output terminals DQ4 to DQ7. That is, the user data Dat read from the memory cell array MCA1 is output via the data signal input/output terminals DQ4 to DQ7. The data signal input/output terminals DQ4 to DQ7 include a signal path for the user data Dat to and from the memory cell array MCA1, but do not include a signal path for the user data Dat to and from the memory cell array MCA0.

The input/output of the user data Dat between the buffer circuits LFIFO and the driver circuits OCD is executed, for example, at 512 MHz. In addition, the input/output of the user data Dat between the driver circuits OCD and the controller die CD (FIG. 1) via the data signal input/output terminals DQ0 to DQ7 is executed, for example, at 1024 MHz.

### [Signal Path for User Data Dat of Memory Die MD' According to Comparative Example]

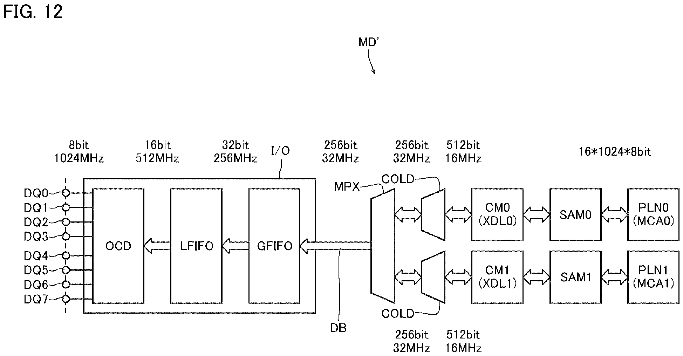

FIG. 12 is a schematic block diagram for describing a signal path for user data Dat of a memory die MD' according to a comparative example.

The driver circuit OCD according to the comparative example includes eight output circuits 202 (FIG. 10) corresponding to the data signal input/output terminals DQ0 to DQ7. These eight output circuits 202 correspond to both the memory cell arrays MCAO, MCA1. That is, in the comparative example, all the data signal input/output terminals DQ0 to DQ7 are used at a time of outputting the user data Dat read from the memory cell array MCA0. Similarly, all the data signal input/output terminals DQ0 to DQ7 are used at a time of outputting the user data Dat read from the memory cell array MCA1.

Here, even in the memory die MD' according to the comparative example, when the user data Dat is output, the user data Dat is transferred from the cache memories CM0, CM1 to the data signal input/output terminals DQ0 to DQ7 at an approximately constant speed (in the illustrated example, 4096 MHz).

Accordingly, in the memory die MD' according to the comparative example, the input/output of the user data Dat between the cache memories CM0, CM1 and the column decoders COLD is executed at twice the speed compared to the first embodiment, for example, at 16 MHz. Therefore, the cache memories CM0, CM1 and the column decoders COLD according to the comparative example are configured to include transistors that operate at twice the speed compared to the first embodiment. For example, the cache memories CM0, CM1 and the column decoders COLD according to the comparative example are composed of transistors with a larger channel width compared to the first embodiment.

In addition, the column decoders COLD are connected to the multiplexer MPX via buses with twice the bus width compared to the first embodiment, for example, 256-bit buses.

### [Effect of Memory Die MD According to First Embodiment]

In the memory die MD according to the first embodiment, the input/output of the user data Dat between the cache memories CM0, CM1 and the column decoders COLD is executed at half the speed compared to the comparative example. Accordingly, the cache memories CM0, CM1 and the column decoders COLD according to the first embodiment can be achieved by transistors with a smaller channel width compared to the comparative example. Therefore, the circuit area can be reduced.

In addition, in the memory die MD according to the first embodiment, the column decoders COLD are connected to the multiplexers MPX via buses with half the bus width compared to the comparative example. Therefore, the circuit area can be reduced.

### [Signal Input Method from Controller Die CD to Memory Die MD]

Next, a signal input method from the controller die CD to the memory die MD according to the embodiment is described.

### [Role of Each Terminal]

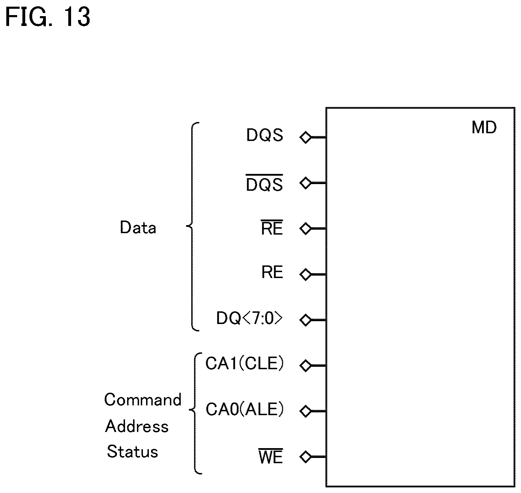

FIG. 13 is a schematic diagram for describing roles of the signal input/output terminals and the control terminals in the memory die MD. In the following description, the data signal input/output terminals DQ0 to DQ7 are referred to as data signal input/output terminals DQ<7:0> in some cases.

For example, as illustrated in FIG. 13, in the memory die MD according to the embodiment, the data signal input/output terminals DQ<7:0> are used to input/output the user data Dat, and they are not used to input the command data Cmd and the address data Add and to output the status data Stt. In addition, in the memory die MD according to the embodiment, the control terminals CA1 (CLE), CA0 (ALE) are used to input the command data Cmd and the address data Add and to output data, such as the status data Stt.

In the following description, a part of the signal input/output via the control terminals CA1 (CLE), CA0 (ALE) is referred to as a header in some cases. Further, a combination of headers that constitute such a signal is referred to as a header set in some cases. The header set includes a 4-bit signal that is input in two cycles in time division.

In addition, a part of data, such as the command data Cmd, the address data Add, the status data Stt, and the feature data Fd, which is input/output following the header, is referred to as a body in some cases. Further, a combination of bodies that constitute such data or a part of the data is referred to as a body set in some cases. The body set includes 8-bit data that is input in four cycles in time division.

Moreover, a combination of one header set and one body set may be referred to as a frame.

The data input or output via the control terminals CA1 (CLE), CA0 (ALE) is taken in a register (not illustrated in FIG. 13) in the logic circuit CTR at timings of a rising edge and a falling edge of a voltage at the control terminal CA_clk (/WE). That is, the data input or output via the control terminals CA1 (CLE), CA0 (ALE) is taken in the register (not illustrated in FIG. 13) in the logic circuit CTR according to a toggle of the signal input to the control terminal CA0 (ALE). In this description, the voltage at the control terminal CA0 (ALE) rises or falls once, and in response to this, 2-bit data is input or output via the control terminals CA1 (CLE), CA0 (ALE), which is defined as one cycle. For example, when the voltage at the control terminal CA_clk (/WE) rises once and further falls, according to this, 4-bit data is input or output via the control terminals CA1 (CLE), CA0 (ALE). This is defined as two cycles.

### [Example of Header Set Input]

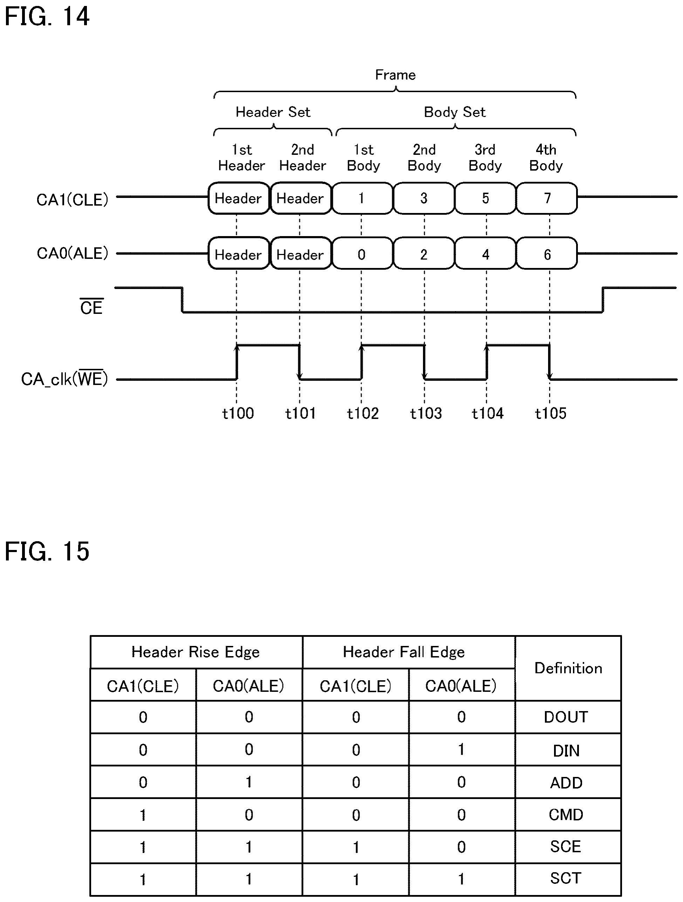

FIG. 14 is a schematic waveform diagram for describing an operation of the memory die MD according to the first embodiment. FIG. 15 is a schematic table for describing the operation of the memory die MD.

In the example of FIG. 14, in a state where a signal in the "L" state is input to the control terminal /CE, a signal in the "L" state and a signal in the "H" state are input to the control terminal CA_clk (/WE) at an approximately constant pace. That is, in a state where the input signal of the control terminal /CE is "L", switching of the input signal (two toggles), in which the input signal of the control terminal CA_clk (/WE) rises once from "L" to "H" and falls from "H" to "L", is repeated.

In the example of FIG. 14, at timing t100 and timing t101, a 4-bit header set is input corresponding to a rising edge and a falling edge of the signal input to the control terminal CA_clk (/WE). More specifically, at timing t100 and timing t101, the controller die CD inputs the 4-bit header set illustrated in FIG. 15 to the memory die MD in two cycles, two bits at a time. For example, when the input of the command data Cmd is instructed (CMD), in the header of the first cycle, the voltages at the control terminals CA1 (CLE), CA0 (ALE) are set according to bits "1", "0". The header of the first cycle is taken in the register (not illustrated in FIG. 14) in the logic circuit CTR at the timing (rising edge) where the control terminal CA_clk (/WE) rises from "L" to "H". In the header of the second cycle, the voltages at the control terminals CA1 (CLE), CA0 (ALE) are set according to bits "0", "0". The header of the second cycle is taken in the register (not illustrated in FIG. 14) in the logic circuit CTR at the timing (falling edge) where the control terminal CA_clk (/WE) falls from "H" to "L".

In addition, in the example of FIG. 14, at timings t102 to t105, an 8-bit body set is input corresponding to the rising edge and the falling edge of the signal input to the control terminal CA_clk (/WE). More specifically, at timings t102 to t105, the controller die CD inputs the 8-bit body set according to the 4-bit header set (entry condition) to the memory die MD in four cycles, two bits at a time. For example, the 8-bit command data Cmd is set to bits "0" to "7". First, in the body (data) of the first cycle, the voltages at the control terminals CA1 (CLE), CA0 (ALE) are set according to bits "1", "0". The body of the first cycle is taken in at the timing (rising edge) where the control terminal CA_clk (/WE) rises from "L" to "H". In the body (data) of the second cycle, the voltages at the control terminals CA1 (CLE), CA0 (ALE) are set according to bits "3", "2". The body of the second cycle is taken in at the timing (falling edge) where the control terminal CA_clk (/WE) falls from "H" to "L". Similarly, the voltages at the control terminals CA1 (CLE), CA0 (ALE) are set according to bits "5", "4" in the body of the third cycle and according to bits "7", "6" in the body of the fourth cycle. The body of the third cycle is taken in at the timing (rising edge) where the control terminal CA_clk (/WE) rises, and the body of the fourth cycle is taken in at the timing (falling edge) where the control terminal CA_clk (/WE) falls.

As illustrated in FIG. 15, when the output of data via the control terminals CA1 (CLE), CA0 (ALE) is instructed (DOUT), bits "0", "0" are input in the header of the first cycle, and bits "0", "0" are input in the header of the second cycle. Such a header set is used, for example, at a time of outputting the status data Stt or the feature data Fd.

In addition, when the input of data via the control terminals CA1 (CLE), CA0 (ALE) is instructed (DIN), bits "0", "0" are input in the header of the first cycle, and bits "0", "1" are input in the header of the second cycle. Such a header set is used, for example, at a time of inputting the feature data Fd.

When the input of the address data Add is instructed (ADD), bits "0", "1" are input in the header of the first cycle, and bits "0", "0" are input in the header of the second cycle.

In the embodiment, the controller die CD inputs a Select Chip Enable (SCE) command to the memory die MD when the input or output of the user data Dat via the data signal input/output terminals DQ0 to DQ7 is started. When the SCE command is input, bits "1", "1" are input in the header of the first cycle, and bits "1", "0" are input in the header of the second cycle.

A body set corresponding to the SCE command ("SCE target") includes, for example, a 4-bit chip address specifying a memory die MD, 1-bit data specifying input or output, and 1-bit data specifying the data signal input/output terminals DQ0 to DQ3 or the data signal input/output terminals DQ4 to DQ7 (or specifying the plane PLN0 or the plane PLN1).

In the embodiment, the controller die CD inputs a Select Chip Terminate (SCT) command to the memory die MD when the input or output of the user data Dat via the data signal input/output terminals DQ0 to DQ7 is terminated. When the SCT command is input, bits "1", "1" are input in the header of the first cycle, and bits "1", "1" are input in the header of the second cycle.

A body set corresponding to the SCT command ("SCT target") includes, for example, a 4-bit chip address specifying a memory die MD, 1-bit data specifying input or output, and 1-bit data specifying the data signal input/output terminals DQ0 to DQ3 or the data signal input/output terminals DQ4 to DQ7 (or specifying the plane PLN0 or the plane PLN1).

The Header Rising edge illustrated in FIG. 15 indicates a 2-bit first header that is input in response to the rising edge of the signal input in the header of the first cycle, that is, the control terminal CA_clk (/WE). The Header Falling edge indicates a 2-bit second header that is input in response to the falling edge of the signal input in the header of the second cycle, that is, the control terminal CA_clk (/WE).

### [Operation]

Next, the operations of the memory die MD are described.

The memory die MD is configured to be able to perform a read operation. The read operation is an operation of reading the user data Dat from the memory cell array MCA by the sense amplifier module SAM and transferring the read user data Dat to the latch circuit XDL. In the read operation, the user data Dat read from the memory cell arrays MCA is transferred to the latch circuits XDL via the bit lines BL and the sense amplifier modules SAM.

In addition, the memory die MD is configured to be able to perform a data-out operation. The data-out operation is an operation of outputting the user data Dat included in the latch circuit XDL to the controller die CD. In the data-out operation, first, a prefetch operation is executed. In the prefetch operation, the user data Dat included in the latch circuit XDL is transferred to the input/output control circuit I/O via the column decoders COLD, the multiplexers MPX, and the bus wiring DB described with reference to FIG. 11. Next, the user data Dat in the input/output control circuit I/O is output to the controller die CD via the data signal input/output terminals DQ0 to DQ7.

In addition, the memory die MD is configured to be able to perform a status read. The status read is an operation of outputting the status data Stt included in the status register STR to the controller die CD. In the status read, the status data Stt included in the status register STR is output to the controller die CD via the logic circuit CTR.

Further, the memory die MD is configured to be able to perform a write operation. The write operation is an operation of inputting the user data Dat from the controller die CD to the memory die MD via the data signal input/output terminals DQ0 to DQ7 and writing this user data Dat into the memory cell array MCA.

### [Read Operation]

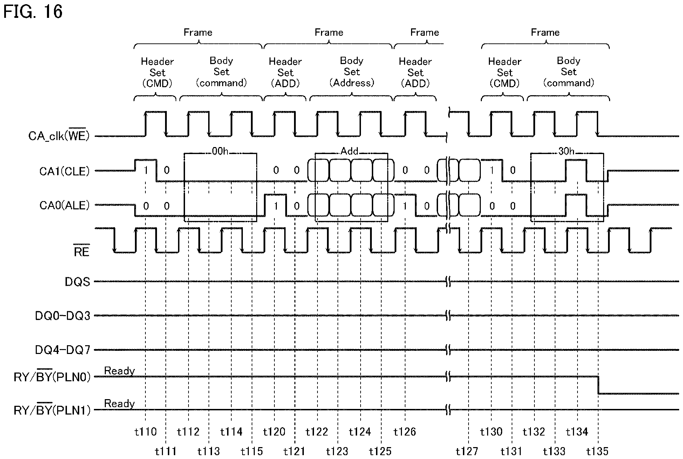

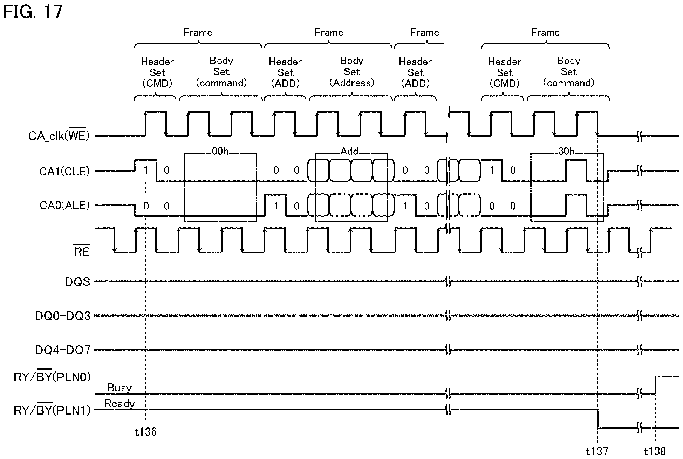

FIG. 16 and FIG. 17 are schematic waveform diagrams illustrating input/output signals between the controller die CD and the memory die MD. FIG. 16 illustrates a timing chart of a read operation corresponding to a memory die MD0. FIG. 17 illustrates a timing chart of a read operation corresponding to a memory die MD1.

Before timing t110 in FIG. 16, although not illustrated, the voltage at the control terminal /CE falls from "H" to "L".

Subsequently, the controller die CD inputs a command set for a read operation to the memory die MD at timings t110 to t135. That is, the controller die CD inputs command data Cmd to instruct a read operation to the memory die MD at timings t110 to t115, inputs address data Add of a page that is a target of the read operation to the memory die MD at timings t120 to t127, and inputs command data Cmd to start the read operation to the memory die MD at timings t130 to t135.

More specifically, at timings t110 to t111, the controller die CD inputs a header set, composed of a header of the first cycle indicating bits "1", "0" and a header of the second cycle indicating bits "0", "0", to the memory die MD via the control terminals CA1 (CLE), CA0 (ALE). This header set is, as illustrated in FIG. 15, the header set that instructs to input the command data Cmd and is input at timings of the rising edge and the falling edge of the signal input to the control terminal CA_clk (/WE). In other words, at timings t110 to t111, a portion corresponding to the header set (4-bit information) of the frame corresponding to the command data Cmd that constitutes the command set for the read operation is input to the memory die MD according to two toggles of the signal input to the control terminal CA_clk (/WE).

At timings t112 to t115, the controller die CD inputs 8-bit data indicating 00h (00000000) as a body set composed of four bodies to the memory die MD via the control terminals CA1 (CLE), CA0 (ALE). 00h is the command data Cmd to instruct a read operation. In other words, at timings t112 to t115, a portion corresponding to the body set (8-bit information) of the frame corresponding to the command data Cmd that constitutes the command set for the read operation is input to the memory die MD according to four toggles of the signal input to the control terminal CA_clk (/WE).

At timings t120 to t121, the controller die CD inputs a header set, composed of a header of the first cycle indicating bits "0", "1" and a header of the second cycle indicating bits "0", "0", to the memory die MD via the control terminals CA1 (CLE), CA0 (ALE). This header set is, as illustrated in FIG. 15, the header set that instructs to input the address data Add and is input at the timings of the rising edge and the falling edge of the signal input to the control terminal CA_clk (/WE). In other words, at timings t120 to t121, a portion corresponding to the header set (4-bit information) of one of the four frames corresponding to the address data Add that constitute the command set for the read operation is input to the memory die MD according to two toggles of the signal input to the control terminal CA_clk (/WE).

At timings t122 to t125, the controller die CD inputs 8-bit data of the address data Add as a body set composed of four bodies to the memory die MD via the control terminals CA1 (CLE), CA0 (ALE). In other words, at timings t122 to t125, a portion corresponding to the body set (8-bit information) of the frame corresponding to the address data Add that constitutes the command set for the read operation is input to the memory die MD according to four toggles of the signal input to the control terminal CA_clk (/WE).

In addition, the same operation as executed at timings t120 to t125 is executed a plurality of times at timings t126 to t127. As a result, all the frames corresponding to the address data Add that constitute the command set for the read operation are input to the memory die MD.

At timings t130 to t131, the controller die CD inputs a header set, composed of a header of the first cycle indicating bits "1", "0" and a header of the second cycle indicating bits "0", "0", to the memory die MD via the control terminals CA1 (CLE), CA0 (ALE).

At timings t132 to t135, the controller die CD inputs 8-bit data indicating 30h (00110000) as a body set composed of four bodies to the memory die MD via the control terminals CA1 (CLE), CA0 (ALE). 30h is the command data Cmd to instruct the start of the read operation.

The command set to instruct the read operation is input from the controller die CD to the memory die MD by the operation at timings t110 to t135. Accordingly, the read operation is started in the memory die MD. In the illustrated example, the address data Add corresponds to the plane PLN0. In such a case, as illustrated in FIG. 16, a ready/busy signal RY//BY (PLNO) corresponding to the plane PLN0 falls from "H" to "L".

The read operation for the plane PLN0 and the read operation for the plane PLN1 are executable in parallel. For example, after the operation described with reference to FIG. 16 is executed, as illustrated in FIG. 17, a command set to instruct the read operation for the plane PLN1 is input from the controller die CD to the memory die MD at timings t136 to t137. Then, the read operation corresponding to the plane PLN1 is started in the memory die MD. Accordingly, a ready/busy signal RY//BY (PLN1) corresponding to the plane PLN1 falls from "H" to "L".

In the illustrated example, the read operation corresponding to the plane PLN0 is terminated at timing t138, and the ready/busy signal RY//BY (PLNO) corresponding to the plane PLN0 rises from "L" to "H".

### [Status Read]

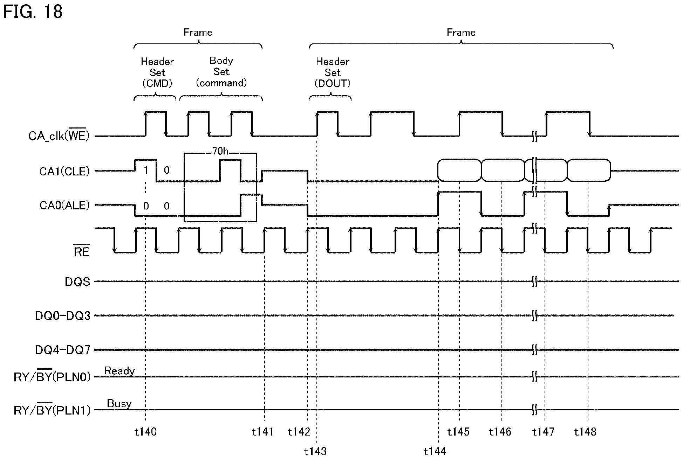

FIG. 18 is a schematic waveform diagram illustrating the input/output signals between the controller die CD and the memory die MD. FIG. 18 illustrates a timing chart of a status read.

Here, as described with reference to FIG. 9 and the like, the memory die MD includes the terminal RY//BY that outputs the ready/busy signal. Therefore, the controller die CD can check whether or not the read operation has been terminated via the ready/busy signal output from the terminal RY//BY. However, only one terminal RY//BY per memory die MD is provided. Basically, a NOR signal of the ready/busy signal RY//BY (PLNO) corresponding to the plane PLN0 and the ready/busy signal RY//BY (PLN1) corresponding to the plane PLN1 is output from the terminal RY//BY. Accordingly, even when the output signal of the terminal RY//BY is checked, basically, it is not possible to confirm separately whether or not the read operation corresponding to the plane PLN0 has been terminated and whether or not the read operation corresponding to the plane PLN1 has been terminated. Therefore, in the illustrated example, after the command sets for the read operation described with reference to FIG. 16 and FIG. 17 are input, a status read is executed to confirm whether or not the read operation corresponding to the plane PLN0 has been terminated.

In the illustrated example, the controller die CD starts to input command data Cmd to instruct a status read to the memory die MD at timing t140.

The input of this command data Cmd is executed approximately similarly to the input of the command data Cmd to instruct a read operation. However, 70h (01110000) is input as the body instead of 00h.

In addition, in the illustrated example, at timing t141, the voltages at the control terminals CA1 (CLE), CA0 (ALE) are switched to an intermediate value between the voltage corresponding to "0" and the voltage corresponding to "1".

In the illustrated example, at timing t142, the voltages at the control terminals CA1 (CLE), CA0 (ALE) are switched to the voltages corresponding to "0".

Further, in the illustrated example, at timing t143, the controller die CD starts to toggle the control terminal CA_clk (/WE).

In addition, in the illustrated example, at timing t144, the output of the status data Stt via the control terminal CA1 (CLE) is started. In the illustrated example, the status data Stt is output one bit at a time via the control terminal CA1 (CLE) in response to the rising edge of the control terminal /RE. Also, the signal of the control terminal CA0 (ALE) is switched at the timing of switching of the status data Stt.

In addition, at timings t145, t146 to t147, and t148, the controller die CD acquires the status data Stt one bit at a time from the memory die MD via the control terminal CA1 (CLE).

### [Data-Out Operation]

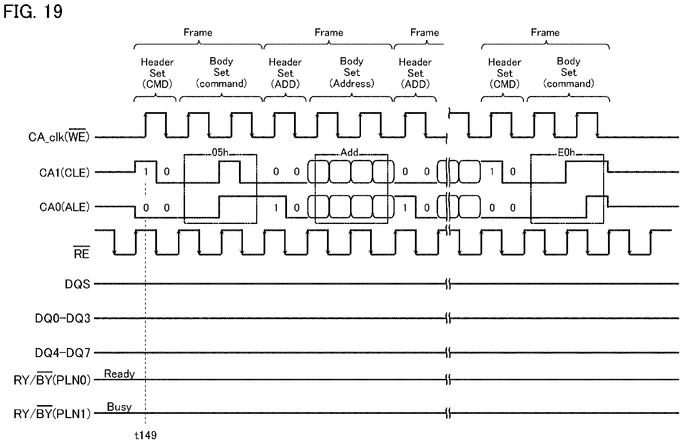

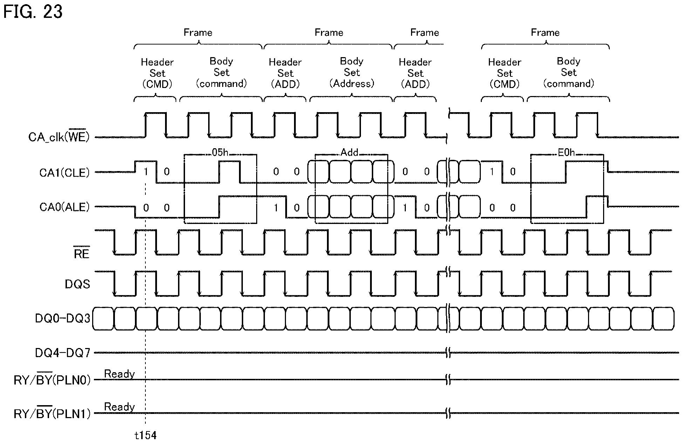

FIG. 19 to FIG. 26 are schematic waveform diagrams illustrating input/output signals between the controller die CD and the memory die MD. FIG. 19 to FIG. 22 and FIG. 25 illustrate timing charts of a data-out operation corresponding to the memory die MD0. FIG. 23, FIG. 24, and FIG. 26 illustrate timing charts of a data-out operation corresponding to the memory die MD1.

In the example of FIG. 19, the controller die CD starts to input a command set for a data-out operation to the memory die MD at timing t149. That is, the controller die CD first inputs command data Cmd to instruct a data-out operation to the memory die MD, next inputs address data Add of a page that is a target of the data-out operation to the memory die MD, and then inputs command data Cmd to start the data-out operation to the memory die MD.

The input of the command data Cmd to instruct a data-out operation is executed approximately similarly to the input of the command data Cmd to instruct a read operation. However, 05h (00000101) is input as the body instead of 00h.

The input of the command data Cmd to start the data-out operation is executed approximately similarly to the input of the command data Cmd to start the read operation. However, E0h (11100000) is input as the body instead of 30h.

As a result, a prefetch operation is started, and the user data Dat in the latch circuit XDL0 is transferred to the input/output control circuit I/O.

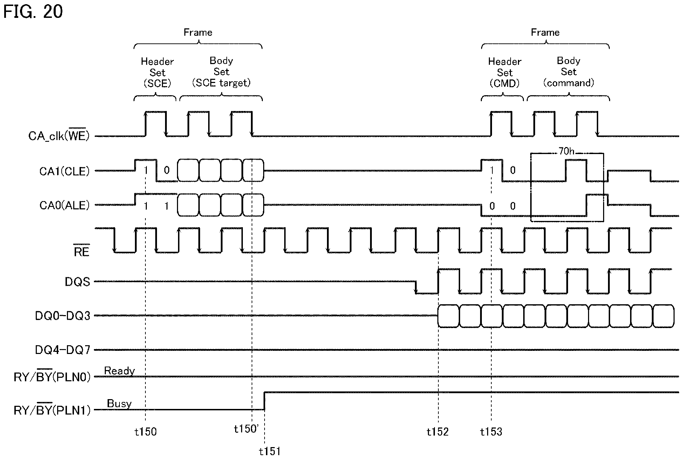

Next, the controller die CD starts to input an SCE command to the memory die MD at timing t150 in FIG. 20.

When the signal of the control terminal /RE is toggled a plurality of times following the input of the SCE command, the output of the user data Dat corresponding to the plane PLN0 is started via the data signal input/output terminals DQ0 to DQ3. In the illustrated example, the voltage at the data strobe signal input/output terminal DQS falls in response to the fourth falling edge of the signal of the control terminal /RE following the input of the SCE command (for example, after the final cycle of the SCE target is accepted at timing t150'). In addition, at timing t152 corresponding to the next rising edge of the control terminal /RE, the user data Dat read from the plane PLN0 is output four bits at a time via the data signal input/output terminals DQ0 to DQ3. Also, the signal of the data strobe signal input/output terminal DQS is switched at the timing of switching of the user data Dat corresponding to the plane PLN0.

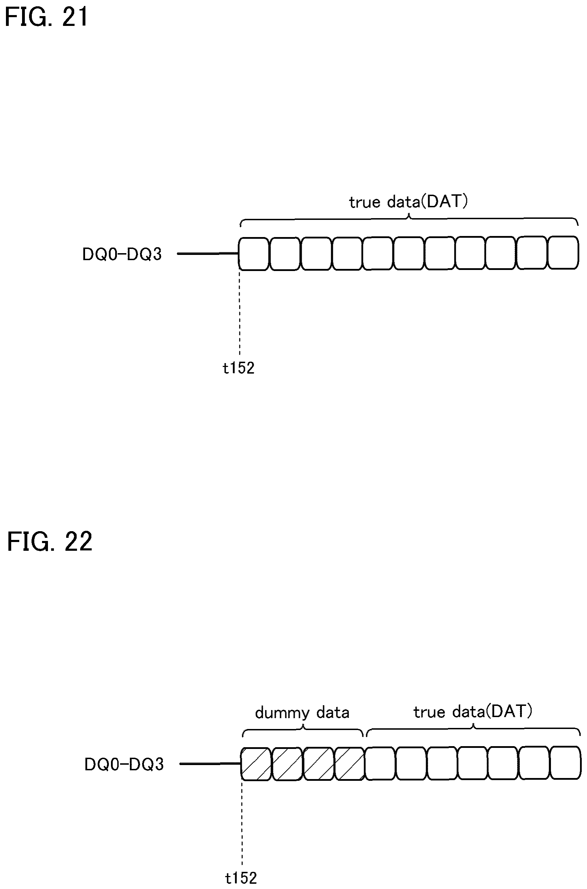

At timing t152, the user data Dat (true data) may be output immediately, for example, as illustrated in FIG. 21, or dummy data may be output before the user data Dat is output, for example, as illustrated in FIG. 22. For example, data of a predetermined number of cycles (for example, four cycles) may be dummy data, not the user data Dat. Accordingly, the user data Dat can be smoothly transmitted to the controller die CD. In addition, the output of the output circuits 202 (FIG. 10) can be stabilized. The number of bits of dummy data may be different between when the read operation corresponding to the plane PLN0 is executed and when the read operation corresponding to the plane PLN1 is executed.

In the example of FIG. 20, the read operation corresponding to the plane PLN1 is terminated at timing t151, and the ready/busy signal RY//BY (PLN1) corresponding to the plane PLN1 rises from "L" to "H". In addition, the controller die CD starts to input the command data Cmd to instruct a status read to the memory die MD at timing t153. Although not illustrated, after the command data Cmd to instruct a status read is accepted, as illustrated at timings t143 to t148 in FIG. 18, the controller die CD acquires the status data Stt one bit at a time from the memory die MD via the control terminal CA1 (CLE). Accordingly, the controller die CD can check the termination of the read operation corresponding to the plane PLN1.

Here, the data-out operation for the plane PLN0 and the data-out operation for the plane PLN1 are executable in parallel.

For example, as illustrated in FIG. 23, at timing t154, when the controller die CD starts to input the command set to instruct the data-out operation for the plane PLN1 to the memory die MD, a prefetch operation is started, and the user data Dat in the latch circuit XDL1 is transferred to the input/output control circuit I/O.

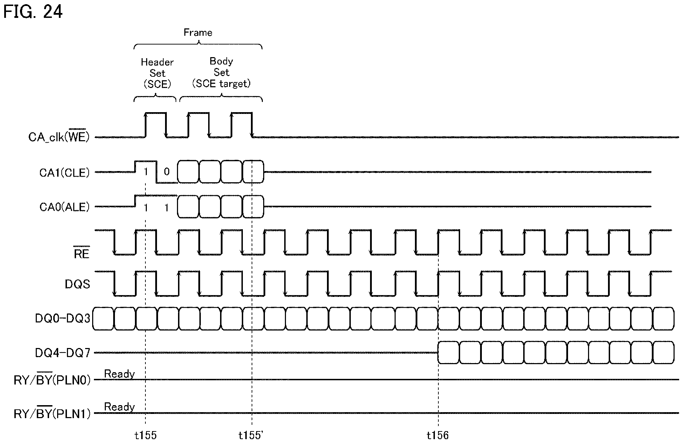

Next, the input of an SCE command to the memory die MD is started at timing t155 in FIG. 24. In the illustrated example, at timing t156 corresponding to the rising edge at a predetermined timing of the control terminal /RE (for example, the next falling edge following the fourth falling edge after the final cycle of the SCE target is accepted at timing t155'), the user data Dat read from the plane PLN1 is output four bits at a time via the data signal input/output terminals DQ4 to DQ7. Also, the signal of the data strobe signal input/output terminal DQS is switched at the timing of switching of the user data Dat corresponding to the plane PLN1.

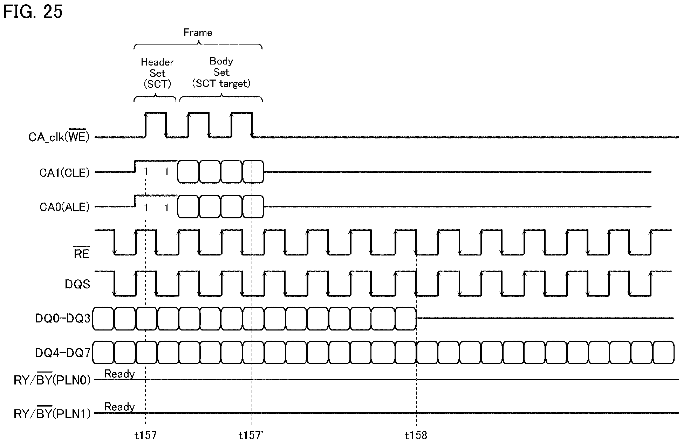

When terminating the acquisition of the user data Dat corresponding to the plane PLNO, the controller die CD starts to input an SCT command to the memory die MD at timing t157 in FIG. 25.

When the signal of the control terminal /RE is toggled a plurality of times following the input of the SCT command, the output of the user data Dat via the data signal input/output terminals DQ0 to DQ3 is terminated. In the illustrated example, the output of the user data Dat corresponding to the plane PLN0 via the data signal input/output terminals DQ0 to DQ3 is terminated at timing t158 corresponding to the fourth falling edge of the signal of the control terminal /RE following the input of the SCT command (for example, after the final cycle of the SCT target is accepted at timing t157'). In the illustrated example, the output of the user data Dat corresponding to the plane PLN1 via the data signal input/output terminals DQ4 to DQ7 has not been terminated. Therefore, the signal of the data strobe signal input/output terminal DQS continues to be switched even after timing t158.

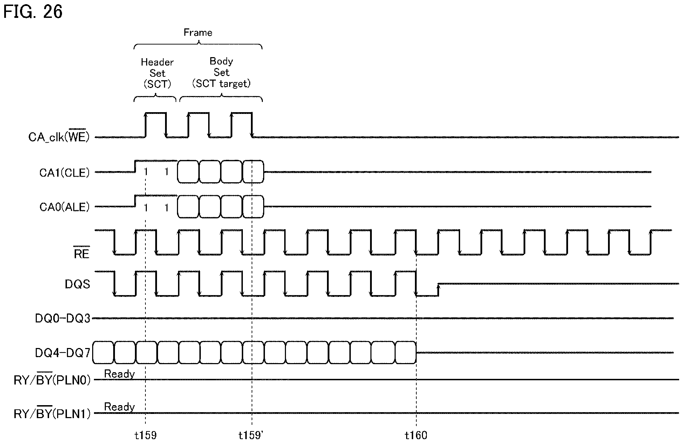

Similarly, when terminating the acquisition of the user data Dat corresponding to the plane PLN1, the controller die CD starts to input an SCT command to the memory die MD at timing t159 in FIG. 26. Accordingly, in the illustrated example, the output of the user data Dat corresponding to the plane PLN1 via the data signal input/output terminals DQ4 to DQ7 is terminated at timing 1160 corresponding to the fourth falling edge of the signal of the control terminal /RE following the input of the SCT command (for example, after the final cycle of the SCT target is accepted at timing t159'). In the illustrated example, all the output of the user data Dat from the memory die MD is terminated at this timing. Therefore, the signal output from the data strobe signal input/output terminal DQS is also terminated. In the illustrated example, the voltage at the data strobe signal input/output terminal DQS is fixed at the intermediate value between the voltage corresponding to "0" and the voltage corresponding to "1".

In the embodiment, the controller die CD continues to toggle the input signal to the control terminal /RE from timing t110 in FIG. 16 to timing t160 in FIG. 26 at an approximately constant frequency.

### [Write Operation]

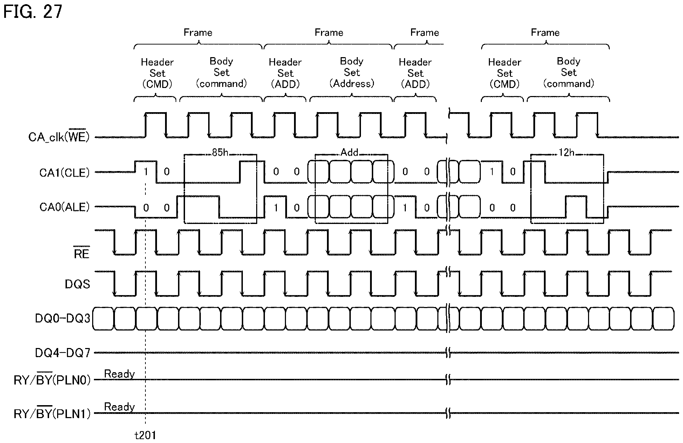

FIG. 27 to FIG. 30 are schematic waveform diagrams illustrating input/output signals between the controller die CD and the memory die MD. FIG. 27 to FIG. 30 illustrate timing charts of a write operation corresponding to the memory die MD1.

The input of a command set for the write operation for the plane PLN0 is executable in parallel with the read operation, the data-out operation, or the write operation for the plane PLN1. Similarly, the write operation for the plane PLN1 is executable in parallel with the read operation, the data-out operation, or the write operation for the plane PLN0. Here, the command set for the write operation includes user data Dat. That is, in the embodiment, the input of the user data Dat to be written to the plane PLN0 is executable in parallel with the output of the user data Dat read from the plane PLN1 and the input of the user data Dat to be written to the plane PLN1. Similarly, the input of the user data Dat to be written to the plane PLN1 is executable in parallel with the output of the user data Dat read from the plane PLN0 and the input of the user data Dat to be written to the plane PLN0.

FIG. 27 to FIG. 30 describes an example in which, as described with reference to FIG. 16 to FIG. 18, after the read operation corresponding to the plane PLN0 is executed, the execution of the data-out operation corresponding to the plane PLN0 is started as illustrated in FIG. 20, and during the execution of this data-out operation, the write operation corresponding to the plane PLN1 is executed.

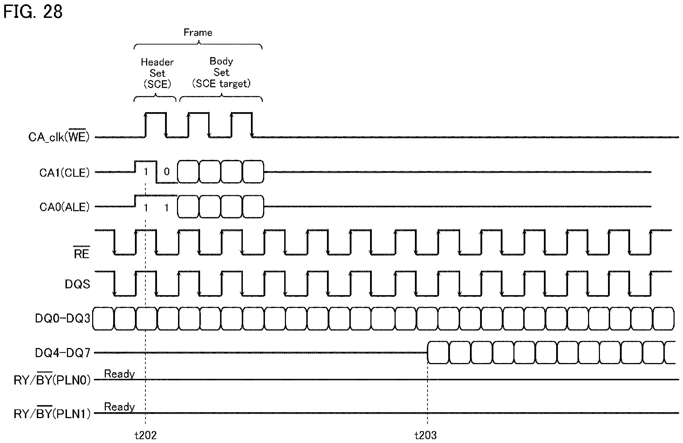

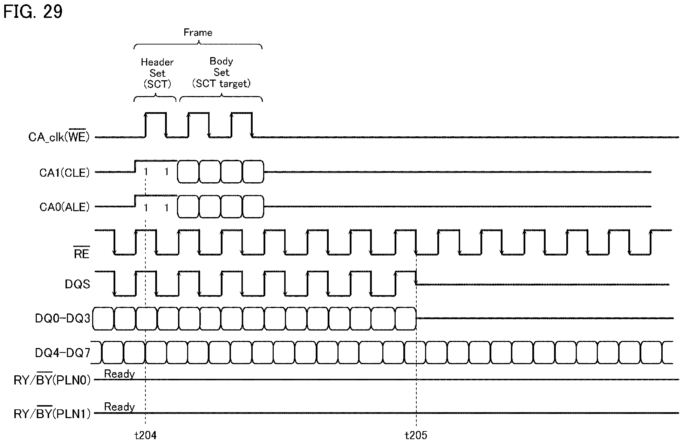

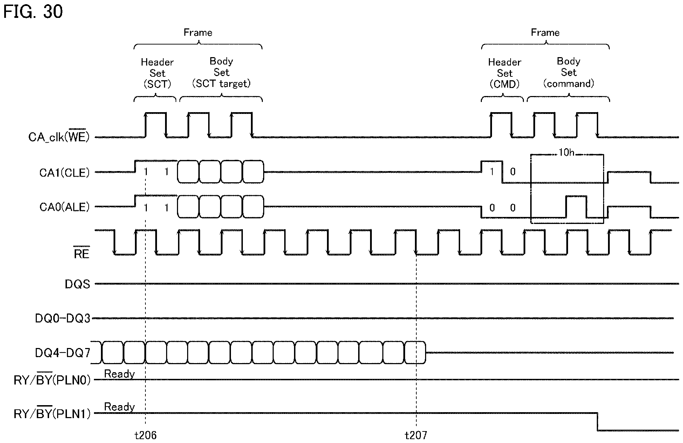

In the example of FIG. 27, the controller die CD starts to input the command set for the write operation to the memory die MD at timing t201. That is, the controller die CD first inputs command data Cmd to instruct a write operation to the memory die MD, next inputs address data Add of a page that is a target of the write operation to the memory die MD, and then inputs command data Cmd indicating the input termination of the address data Add to the memory die MD. Next, as illustrated in FIG. 28 and FIG. 29, the controller die CD inputs the user data Dat to write to the memory cell array MCA to the memory die MD. Next, as illustrated in FIG. 30, the controller die CD inputs command data Cmd to start the write operation to the memory die MD.

In the example of FIG. 27, the controller die CD starts to input the command data Cmd to instruct a write operation to the memory die MD at timing t201.

The input of the command data Cmd to instruct a write operation is executed approximately similarly to the input of the command data Cmd to instruct a read operation. However, 85h (10000101) is input as the body instead of 00h.

The input of the command data Cmd indicating the input termination of the address data Add is executed approximately similarly to the input of the command data Cmd to instruct a read operation. However, 12h (00010010) is input as the body instead of 00h.

Next, the controller die CD starts to input an SCE command to the memory die MD at timing t202 in FIG. 28.

When the signal of the control terminal /RE is toggled predetermined times or more following the input of the SCE command, the input of the user data Dat corresponding to the plane PLN1 is started via the data signal input/output terminals DQ4 to DQ7. In the illustrated example, at timing t203 between the fourth falling edge of the signal of the control terminal /RE following the input of the SCE command and the rising edge immediately after that, the user data Dat to be written to the plane PLN1 is input four bits at a time via the data signal input/output terminals DQ4 to DQ7.

At timing t203, dummy data may be input before the user data Dat is input. For example, data of a predetermined number of cycles (for example, four cycles) may be dummy data, not the user data Dat. Accordingly, the user data Dat can be smoothly input to the memory die MD. In addition, the output of the input circuits 201 (FIG. 10) can be stabilized. The number of bits of dummy data may be different between when the write operation corresponding to the plane PLN0 is executed and when the write operation corresponding to the plane PLN1 is executed.

Next, the controller die CD starts to input an SCT command to the memory die MD at timing t204 in FIG. 29.

When the signal of the control terminal /RE is toggled a plurality of times following the input of the SCT command, the output of the user data Dat via the data signal input/output terminals DQ0 to DQ3 is terminated. In the illustrated example, the output of the user data Dat corresponding to the plane PLN0 via the data signal input/output terminals DQ0 to DQ3 is terminated at timing t205 corresponding to the fourth falling edge of the signal of the control terminal /RE following the input of the SCT command. In the illustrated example, all the output of the user data Dat from the memory die MD is terminated at this timing. Therefore, the signal output from the data strobe signal input/output terminal DQS is also terminated.

Next, the controller die CD starts to input an SCT command to the memory die MD at timing t206 in FIG. 30.

When the signal of the control terminal /RE is toggled predetermined times or more following the input of the SCT command, the input of the user data Dat via the data signal input/output terminals DQ4 to DQ7 is terminated. In the illustrated example, the output of the user data Dat corresponding to the plane PLN1 via the data signal input/output terminals DQ4 to DQ7 is terminated at timing t207 corresponding to the fourth falling edge of the signal of the control terminal /RE following the input of the SCT command.

Next, the controller die CD starts to input the command data Cmd to start a write operation to the memory die MD at timing t207.

The input of the command data Cmd to start the write operation is executed approximately similarly to the input of the command data Cmd to instruct a read operation. However, 10h (00010000) is input as the body instead of 00h.

In the embodiment, the controller die CD continues to toggle the input signal to the control terminal /RE from timing t110 in FIG. 16 to timing t207 in FIG. 30 at an approximately constant frequency.

### [Other Embodiments]

The memory system and the memory die MD according to the first embodiment have been described above. However, the first embodiment is merely an example, and specific configurations and the like are appropriately adjustable.

For example, as described with reference to FIG. 5 and the like, the memory die MD according to the first embodiment includes two memory cell arrays MCA. However, the memory die MD may include three or more memory cell arrays MCA. For example, when the memory die MD includes four memory cell arrays MCA, the data signal input/output terminals DQ0, DQ1 may be assigned to the first memory cell array MCA, the data signal input/output terminals DQ2, DQ3 may be assigned to the second memory cell array MCA, the data signal input/output terminals DQ4, DQ5 may be assigned to the third memory cell array MCA, and the data signal input/output terminals DQ6, DQ7 may be assigned to the fourth memory cell array MCA.

In addition, in the memory die MD according to the first embodiment, each of the data signal input/output terminals DQ0 to DQ7 is assigned to only one memory cell array MCA. That is, in the memory die MD according to the first embodiment, the data signal input/output terminals DQ0 to DQ3 are assigned to only the first memory cell array MCA, and the data signal input/output terminals DQ4 to DQ7 are assigned to only the second memory cell array MCA. However, the data signal input/output terminals DQ0 to DQ7 can be assigned to two or more memory cell arrays MCA. For example, when the memory die MD includes four memory cell arrays MCA, the data signal input/output terminals DQ0 to DQ3 may be assigned to the first and second memory cell arrays MCA, and the data signal input/output terminals DQ4 to DQ7 may be assigned to the third and fourth memory cell arrays MCA.

Further, in the memory die MD according to the first embodiment, the input of the user data Dat to be written to the plane PLN0 is executable in parallel with the output of the user data Dat read from the plane PLN1 and the input of the user data Dat to be written to the plane PLN1. Similarly, the input of the user data Dat to be written to the plane PLN 1 is executable in parallel with the output of the user data Dat read from the plane PLN0 and the input of the user data Dat to be written to the plane PLN0. However, these configurations are merely examples, and specific configurations are appropriately adjustable.

For example, configuring the input of the user data Dat to be written to the plane PLN0 to be executable in parallel with the output of the user data Dat read from the plane PLN1 is not necessarily a required function. Similarly, configuring the input of the user data Dat to be written to the plane PLN1 to be executable in parallel with the output of the user data Dat read from the plane PLN0 is not necessarily a required function. These functions can be omitted as appropriate.

### [Others]

While certain embodiments have been described, these embodiments have been presented by way of example only, and are not intended to limit the scope of the inventions. Indeed, the novel devices and methods described herein may be embodied in a variety of other forms; furthermore, various omissions, substitutions and changes in the form of the embodiments described herein may be made without departing from the spirit of the inventions. The accompanying claims and their equivalents are intended to cover such forms or modification as would fall within the scope and spirit of the inventions.

## Claims

1. A memory system comprising:
a plurality of semiconductor memory devices (MD); and
a control device (CD), wherein
each of the plurality of semiconductor memory devices (MD) includes:
a first memory cell array (PLNO) including a plurality of first memory cell transistors connected in series;
a second memory cell array (PLN1) including a plurality of second memory cell transistors connected in series;
a first data signal input/output terminal (DQO-DQ3) usable for an output of data read from the first memory cell array (PLNO) and an input of data to be written to the first memory cell array (PLNO);
a second data signal input/output terminal (DQ4-DQ7) usable for an output of data read from the second memory cell array (PLN1) and an input of data to be written to the second memory cell array (PLN1); and
a first control terminal (/RE) configured to accept a toggle signal from the control device (CD) at a time of outputting data read from at least one of the first memory cell array (PLNO) and the second memory cell array (PLN1), wherein
the control device (CD) toggles a signal of the first control terminal (/RE) at an approximately constant frequency regardless of whether or not an input/output of data via the first data signal input/output terminal (DQ0-DQ3) or the second data signal input/output terminal (DQ4-DQ7) is being executed.

2. The memory system according to claim 1, wherein
the first data signal input/output terminal (DQO-DQ3) includes a signal path for data to and from the first memory cell array (PLN0),
the first data signal input/output terminal (DQO-DQ3) does not include a signal path for data to and from the second memory cell array (PLN1),
the second data signal input/output terminal (DQ4-DQ7) includes a signal path for data to and from the second memory cell array (PLN1), and
the second data signal input/output terminal (DQ4-DQ7) does not include a signal path for data to and from the first memory cell array (PLNO).

3. The memory system according to claim 1, wherein
the data read from the first memory cell array (PLNO) is output from the first data signal input/output terminal (DQ0-DQ3) and is not output from the second data signal input/output terminal (DQ4-DQ7), and
the data read from the second memory cell array (PLN1) is output from the second data signal input/output terminal (DQ4-DQ7) and is not output from the first data signal input/output terminal (DQO-DQ3).

4. The memory system according to claim 1, wherein
the control device (CD) toggles a signal of the first control terminal (/RE) at the approximately constant frequency from a timing of an input start of a command set that instructs the semiconductor memory device (MD) to perform a read operation to a timing when an input termination of a command set that instructs the semiconductor memory device (MD) to perform a data-out operation.

5. The memory system according to claim 1, wherein
at a start of a data-out operation, the control device (CD) inputs a command set that instructs a data-out operation and a first command to the semiconductor memory device (MD), and
the semiconductor memory device (MD) starts an output of data after the first control terminal (/RE) is toggled a plurality of times following the input of the first command.

6. The memory system according to claim 1, wherein
at a start of a data-out operation, the control device (CD) inputs a command set that instructs a data-out operation and a first command to the semiconductor memory device (MD), and
the semiconductor memory device (MD) outputs dummy data after the first control terminal (/RE) is toggled a plurality of times following the input of the first command, and then starts an output of data.

7. The memory system according to claim 5, wherein
at a termination of the data-out operation, the control device (CD) inputs a second command to the semiconductor memory device (MD), and
the semiconductor memory device (MD) terminates the output of data after the first control terminal (/RE) is toggled a plurality of times following the input of the second command.

8. The memory system according to claim 6, wherein
at a termination of the data-out operation, the control device (CD) inputs a second command to the semiconductor memory device (MD), and
the semiconductor memory device (MD) terminates the output of data after the first control terminal (/RE) is toggled a plurality of times following the input of the second command.

9. The memory system according to claim 1, wherein
each of the plurality of semiconductor memory devices (MD) further includes a data strobe signal input/output terminal (DQS), and
at a time of a data-out operation, data to be output via at least one of the first data signal input/output terminal (DQ0-DQ3) and the second data signal input/output terminal (DQ4-DQ7) is switched at timings of a falling edge and a rising edge of a voltage at the data strobe signal input/output terminal (DQS).

10. The memory system according to claim 1, wherein
each of the plurality of semiconductor memory devices (MD) further includes a data strobe signal input/output terminal (DQS), and
in a case where:
a data-out operation corresponding to the first memory cell array (PLNO) is started at a first timing;
a data-out operation corresponding to the second memory cell array (PLN1) is started at a second timing after the first timing;
the data-out operation corresponding to the first memory cell array (PLNO) is terminated at a third timing after the second timing; and
the data-out operation corresponding to the second memory cell array (PLN1) is terminated at a fourth timing after the third timing,
a signal of the data strobe signal input/output terminal (DQS) continues to be switched from the first timing to the fourth timing.

11. The memory system according to claim 1, wherein
the input of data to be written to the first memory cell array (PLNO) is executable in parallel with an output of data read from the second memory cell array (PLN1) and the input of data to be written to the second memory cell array (PLN1).

12. A semiconductor memory device comprising:
a first memory cell array (PLNO) including a plurality of first memory cell transistors connected in series;
a second memory cell array (PLN1) including a plurality of second memory cell transistors connected in series;
a first data signal input/output terminal (DQ0-DQ3) usable for an output of data read from the first memory cell array (PLNO) and an input of data to be written to the first memory cell array (PLNO); and
a second data signal input/output terminal (DQ4-DQ7) usable for an output of data read from the second memory cell array (PLN1) and an input of data to be written to the second memory cell array (PLN1), wherein
the first data signal input/output terminal (DQO-DQ3) includes a signal path for data to and from the first memory cell array (PLN0),
the first data signal input/output terminal (DQO-DQ3) does not include a signal path for data to and from the second memory cell array (PLN1),
the second data signal input/output terminal (DQ4-DQ7) includes a signal path for data to and from the second memory cell array (PLN1), and
the second data signal input/output terminal (DQ4-DQ7) does not include a signal path for data to and from the first memory cell array (PLNO).

13. The semiconductor memory device according to claim 12, wherein
the data read from the first memory cell array (PLNO) is output from the first data signal input/output terminal (DQ0-DQ3) and is not output from the second data signal input/output terminal (DQ4-DQ7), and
the data read from the second memory cell array (PLN1) is output from the second data signal input/output terminal (DQ4-DQ7) and is not output from the first data signal input/output terminal (DQO-DQ3).

14. The semiconductor memory device according to claim 12, further comprising
a first control terminal (/RE), wherein
the semiconductor memory device (MD) starts an output of data after the first control terminal (/RE) is toggled a plurality of times following an input of a first command.

15. The semiconductor memory device according to claim 12, further comprising
a first control terminal (/RE), wherein
the semiconductor memory device (MD) outputs dummy data after the first control terminal (/RE) is toggled a plurality of times following an input of a first command, and then starts an output of data.

16. The semiconductor memory device according to claim 14, wherein
the semiconductor memory device (MD) terminates the output of data after the first control terminal (/RE) is toggled a plurality of times following an input of a second command.

17. The semiconductor memory device according to claim 15, wherein
the semiconductor memory device (MD) terminates the output of data after the first control terminal (/RE) is toggled a plurality of times following an input of a second command.

18. The semiconductor memory device according to claim 12, further comprising
a data strobe signal input/output terminal (DQS), wherein
at a time of a data-out operation, data to be output via at least one of the first data signal input/output terminal (DQ0-DQ3) and the second data signal input/output terminal (DQ4-DQ7) is switched at timings of a falling edge and a rising edge of a voltage at the data strobe signal input/output terminal (DQS).

19. The semiconductor memory device according to claim 12, further comprising
a data strobe signal input/output terminal (DQS), wherein
in a case where:
a data-out operation corresponding to the first memory cell array (PLNO) is started at a first timing;
a data-out operation corresponding to the second memory cell array (PLN1) is started at a second timing after the first timing;
the data-out operation corresponding to the first memory cell array (PLNO) is terminated at a third timing after the second timing; and
the data-out operation corresponding to the second memory cell array (PLN1) is terminated at a fourth timing after the third timing,
a signal of the data strobe signal input/output terminal (DQS) continues to be switched from the first timing to the fourth timing.

20. The semiconductor memory device according to claim 12, wherein
the input of data to be written to the first memory cell array (PLNO) is executable in parallel with an output of data read from the second memory cell array (PLN1) and the input of data to be written to the second memory cell array (PLN1).
